# EUROPÄISCHE PATENTSCHRIFT

(11) **EP 4 099 092 B1**
(45) Veröffentlichungstag und Bekanntmachung des Hinweises auf die Patenterteilung: **15.03.2023**
(21) Anmeldenummer: 21177401.3
(22) Anmeldetag: 02.06.2021
(51) Int. Cl.: G03F 7/20, G03F 7/00

(54) **LITHOGRAPHISCHES VERFAHREN ZUR AUFPRÄGUNG VON DREIDIMENSIONALEN MIKROSTRUKTUREN MIT ÜBERGROSSEN STRUKTURHÖHEN IN EIN TRÄGERMATERIAL**
LITHOGRAPHIC METHOD FOR EMBOSSING THREE-DIMENSIONAL MICROSTRUCTURES WITH OVERSIZED STRUCTURE HEIGHTS IN A SUBSTRATE
PROCÉDÉ LITHOGRAPHIQUE DESTINÉ À L'ESTAMPAGE DES MICROSTRUCTURES TRIDIMENSIONNELLES À DES HAUTEURS DE STRUCTURE SURDIMENSIONNÉES DANS UN MATÉRIAU PORTEUR

(43) Veröffentlichungstag der Anmeldung: 07.12.2022
(73) Patentinhaber: Joanneum Research Forschungsgesellschaft mbH, 8010 Graz (AT)
(72) Erfinder: Kuna, Ladislav, 8182 Puch bei Weiz (AT); Postl, Markus, 8010 Graz (AT); Stadlober, Barbara, 8044 Graz (AT)
(74) Vertreter: Patentanwaltskanzlei Matschnig & Forsthuber OG

(56) Entgegenhaltungen:
- WO-A1-2021/071484
- DE-A1-102008 006 438
- US-A1- 2010 099 051
- US-A1- 2019 278 005

## Beschreibung

Die Erfindung betrifft ein lithographisches Verfahren zur Aufprägung von dreidimensionalen Mikrostrukturen mit großen Strukturhöhen in ein photostrukturierbares Trägermaterial.

Im Zuge der Miniaturisierung in vielen Gebieten der Techniken haben in letzter Zeit Mikrostrukturen zahlreiche neue Anwendungsfelder beispielsweise in den Bereichen der Optoelektronik, der Photonik, der Bildverarbeitungssensorik, auf dem Gebiet der Machine Vision, der Robotik sowie in Motion-Control-Systemen gefunden. Es besteht in diesen und weiteren Anwendungsbereichen oftmals das Erfordernis, effizient ein-, zwei-, und/oder dreidimensionale Mikrostrukturen auch mit größeren Strukturhöhen bzw. Strukturtiefen beispielsweise von 100 Mikrometer (µm) beginnend bis zum Sub-Millimeter (mm)-Maßstab rasch und mit höchstmöglicher Präzisierung in einem Trägermaterial herstellen zu können. Weiters besteht die Anforderung, dass neben der Herstellung von Trägermaterialien, die eindimensionale (kurz: 1D), zweidimensionale (kurz: 2D) und/oder dreidimensionale (kurz: 3D) Mikrostrukturen gegebenenfalls mit Überhängen bzw. Kavitäten aufweisen, weiters auch sogenannte 2,5D-Mikrostrukturen in ein Trägermaterial abgeformt werden können. Unter dem Begriff "2,5D" versteht der Fachmann Objekte bzw. Strukturen, die an sich dreidimensional (3D) sind, jedoch keine definierte Unterkante aufweisen. Insbesondere können 2,5D-Mikrostrukturen Hinterschneidungen, Unterschneidungen und/oder Überhänge aufweisen. Beispielsweise werden sphärische Linsen, die an ihren Unterkanten abgerundet sind, als 2,5D-Strukturen bezeichnet. Derartige 2,5D-Mikrostrukturen können beispielsweise für optische Anwendungen eingesetzt werden.

Im Rahmen der vorliegenden Erfindung ist unter dem Begriff einer Strukturhöhe der Mikrostruktur gleichbedeutend auch eine Strukturtiefe der Mikrostruktur zu verstehen. In einem dreidimensionalen kartesischen Koordinatensystem kann beispielsweise eine flächige Mikrostruktur mit einer Länge in X-Achsenrichtung sowie einer Breite in Y-Achsenrichtung angegeben werden. Die Strukturhöhen der Mikrostruktur werden in Z-Achsenrichtung angegeben, die der Höhenanzeige dient. Vertiefungen bzw. Kavitäten der Mikrostruktur, die von einem Flächenniveau aus gemessen werden können, können auch als Strukturtiefen in negativer Z-Achsenrichtung angegeben werden. Der Einfachheit halber wird im Folgenden meist von Strukturhöhen gesprochen.

Aus dem Stand der Technik sind dazu bereits zwei unterschiedliche Methoden bekannt, wobei beide Methoden Photonen zur Strukturierung der Mikrostrukturen nutzen:
Bei der maskenlosen Ein-Photonen-Laserstrahllithographie (kurz: 1PL) wird eine Schicht eines Positiv-Photolacks mittels einer virtuellen, digitalen Photomaske belichtet und nachfolgend entwickelt. Mit Hilfe der virtuellen Photomaske können einzelne Punkte der Photolackschicht durch lokale Variation einer individuellen Lichtdosis entsprechend unterschiedlich belichtet und im Zusammenwirken mit der nachfolgenden einmaligen Entwicklung somit individuell strukturiert werden.

Nachteilig ist allerdings dabei, dass aufgrund einer exponentiell mit der Schichtdicke des Photolacks zunehmenden Lichtabsorption die Eindringtiefe beim Belichten des Photolacks stark limitiert ist. Damit einhergehend unterliegt auch die mögliche maximale Strukturhöhe bzw. Strukturtiefe, mit der der Photolack strukturiert werden kann, derselben Limitierung. Eine Erhöhung der Lichtdosis, also der Lichtintensität pro belichteter Fläche, kann jedoch ab einer bestimmten Grenze zur Zerstörung des Photolacks führen. Derzeit am Markt erhältliche Positiv-Photolacke können üblicherweise mit einer Lichtdosis von höchstens 1200 mWs/cm² belichtet werden. Beim Einsatz einer einzigen Schicht eines Positiv-Photolacks ist die Herstellung von Mikrostrukturen daher mit einer maximalen Strukturhöhe bzw. Strukturtiefe von höchstens 100 µm (Mikrometer) limitiert.

Weiters ist aus dem Stand der Technik die sogenannte direkte Zwei-Photonen-Laserstrahllithographie (kurz: 2PL) bekannt, die beispielsweise zur additiven Fertigung von mikrooptischen Strukturen auf einer schon vorgefertigten 3D-Makrooptik angewendet werden kann.

Die Strukturierung eines Trägermaterials basiert dabei auf der sequentiellen Abtastung eines sogenannten "Voxel" anhand einer virtuellen 3D-Photomaske sowie der nachfolgenden einmaligen Entwicklung des Photolacks. Unter dem Begriff "Voxel", einer aus dem Englischen stammenden Kombination der Abkürzungs-Silben "vox" für "volume" und "el" für "elements", versteht man in der Computergrafik einen Gitterpunkt bzw. Bildpunkt in einem dreidimensionalen Gitter. Bei einem räumlichen Datensatz, der in diskreter Form in kartesischen Koordinaten vorliegt, bezeichnet Voxel den diskreten Wert an einer XYZ-Koordinate des Datensatzes.

Nachteilig an dieser Methode, mit der an sich auch 2,5D- und echte 3D-Strukturen mit Strukturhöhen im Millimeter-Bereich hergestellt werden können, ist die sehr langsame Schreibgeschwindigkeit von derzeit etwa nur 3 mm² je Stunde. Die Layerhöhe jeder einzelnen geschriebenen Strukturschicht entspricht bei dieser Methode dabei einer Voxel-Größe, das heißt, der Größe eines Bildpunktes von weniger als einem Mikrometer (µm). Diese Technik ist daher auf zu strukturierende Gesamtflächen von höchstens einigen Quadratmillimetern limitiert. Zudem können aufgrund der zu langsamen Prozessierungszeit solche Mikrostrukturen weder effizient, noch kostengünstig und nur mit geringem Durchsatz erzeugt werden.

Eine dritte bereits bekannte Technologie ist die Diamantdrehtechnik, die allerdings prinzipiell auf die Fertigung rotationssymmetrischer Objekte beschränkt ist. Auch die Ultra-Präzisions-Diamantdrehtechnik, die an sich zwar auch zur Strukturierung von 3D-Strukturen im Mikrometer-Maßstab entwickelt wurde, hat Schwachstellen. So weichen die Strukturen bei mittels der Ultra-Präzisions-Diamantdrehtechnik hergestellten Werkstücken für gewöhnlich im Mikrometermaßstab von der vorgegebenen Strukturform ab. Abweichungen von bis zu 3 Mikrometer (µm) sind dabei üblich, weshalb die Diamantdrehtechnik zur präzisen Strukturierung von Mikrostrukturen nicht geeignet ist.

DE10 2008 006438A1 offenbart ein Lithographieverfahren zur Herstellung von 3D Strukturen, bei welchem eine einzelne Photolackschicht schichtweise belichtet wird. Es erfolgt jedoch nur ein einziger Entwicklungsschritt im Anschluss der vollständigen Belichtung aller Schichten. DE10 2008 006438A1 offenbart eine Dicke der Photolackschicht von 10 µm, d.h. die Gesamthöhe der erzeugten Mikrostruktur ist deutlich kleiner als die maximale Nenneindringtiefe der elektromagnetischen Strahlung.

US2019/278005A1 offenbart ein Lithographieverfahren zur Erzeugung von 3D Mikrostrukturen, bei welchem iterativ (dünne) Photolackschichten aufgetragen, belichtet und entwickelt werden.

US2010/099051A1 offenbart ein Lithographieverfahren zur Erzeugung von 3D Mikrostrukturen, bei welchem eine Photolackschicht, die dicker (20µm) als die Fokustiefe des verwendeten Laser-Direktschreibers ist, schichtweise belichtet wird. Es erfolgt jedoch nur ein einziger Entwicklungsschritt im Anschluss an die vollständige Belichtung.

WO2021/071484A1 offenbart ein Lithographieverfahren zur Kontrolle der Flankenwinkel, bei welchem eine einzelne Photolackschicht schichtweise belichtet und entwickelt wird. Das schichtweise Entwickeln der bereits belichteten Schichten wird in WO2021/071484A1 lediglich als eine Möglichkeit dargestellt, ein einziger Entwicklungsprozess im Anschluss an die vollständige Belichtung wird alternativ offenbart.

Die vorliegende Erfindung stellt sich daher die Aufgabe, ein verbessertes lithographisches Verfahren zur Aufprägung von dreidimensionalen Mikrostrukturen, welche große Strukturhöhen aufweisen, in ein Trägermaterial, anzugeben. Das neuartige Verfahren soll dabei die aus dem Stand der Technik bekannten Nachteile überwinden:
Insbesondere im Vergleich zur Ein-Photonen-Laserstrahllithographie (1PL-Methode) soll es mit dem neuartigen Verfahren möglich sein, auch Mikrostrukturen mit einer Strukturhöhe bzw. Strukturtiefe von mehr als 100 Mikrometer (µm) rasch und mit hoher Präzision fertigen zu können.

Im Vergleich zur Zwei-Photonen-Laserstrahllithographie (2PL-Methode) soll es mit dem neuartigen Verfahren möglich sein, auch vergleichsweise großflächige Mikrostrukturen beispielsweise mit einigen Quadratzentimetern an Grundfläche rasch und mit hohem Durchsatz herzustellen.

Diese Aufgaben werden von einem lithographischen Verfahren der eingangs genannten Art mit den Merkmalen von Anspruch 1 gelöst. Vorteilhafte Ausgestaltungen und Fortbildungen der Erfindung sind in den Unteransprüchen und der Beschreibung dargelegt.

Erfindungsgemäß umfasst ein Lithographisches Verfahren zur Aufprägung von dreidimensionalen Mikrostrukturen, welche übergroße Strukturhöhen aufweisen, in ein photostrukturierbares Trägermaterial unter Verwendung einer Belichtungsvorrichtung, wobei in Abhängigkeit von Belichtungsparametern der Belichtungsvorrichtung im Zusammenhang mit Belichtungseigenschaften des photostrukturierbaren Trägermaterials eine maximale Nenneindringtiefe der Belichtung und damit eine resultierende Photostrukturierung des Trägermaterials einhergeht und eine übergroße Strukturhöhe eine Höhe aufweist, die den Wert der maximalen Nenneindringtiefe überschreitet, die folgenden Verfahrensschritte:
- a- Flächiges Auftragen eines photostrukturierbaren Trägermaterials auf einem Substratträger, wobei das aufgetragene Trägermaterial eine Schichthöhe aufweist sowie eine plane Oberfläche auf der dem Substratträger gegenüberliegenden Oberseite hat, und wobei die Eigenschaften des Trägermaterials durch Belichten mit elektromagnetischer Strahlung veränderbar sind;
- b- Heranziehen von Informationsdaten als Eingangsgröße, wobei diese Informationsdaten Angaben zur maximalen Nenneindringtiefe des gewählten photostrukturierbaren Trägermaterials sowie zur geometrischen Form einer aufzuprägenden dreidimensionalen Mikrostruktur aufweisend eine übergroße Strukturhöhe enthalten;
- c- Rechnerunterstütztes Modellieren eines virtuellen dreidimensionalen Strukturmodells der aufzuprägenden Mikrostruktur in Abhängigkeit von den Informationsdaten gemäß Schritt -b-, wobei das Strukturmodell Topographiedaten der abzuformenden Mikrostruktur umfasst und anhand der Topographiedaten eine Gesamthöhe des Strukturmodells zu der abzuformenden Mikrostruktur bestimmt wird, welche Gesamthöhe größer als die maximale Nenneindringtiefe der elektromagnetischen Strahlung beim Belichten in das Trägermaterial sowie kleiner als die aufgetragene Schichthöhe des Trägermaterials ist;
- d- Rechnerunterstütztes Unterteilen der Gesamthöhe des dreidimensionalen Strukturmodells in eine Anzahl N(N ≥ 2 bis n), wobei die Anzahl N eine Laufvariable von N ≥ 2 bis N = n ist, von sequentiell übereinandergestapelten Höhenschichten, wobei jede der N (N ≥ 2 bis n) Höhenschichten einer einzelnen Teilstruktur des Strukturmodells entspricht, und wobei jede einzelne der N (N ≥ 2 bis n) Teilstrukturen jeweils eine Teilhöhe hat, wobei die Anzahl N eine ganze Zahl ist, welche größer oder gleich der Zahl 2 ist, und wobei die Anzahl N (N ≥ 2 bis n) so ausgewählt wird, dass jede der N (N ≥ 2 bis n) Teilhöhen kleiner oder gleich der möglichen Nenneindringtiefe der durch die Belichtungsvorrichtung lieferbaren elektromagnetischen Strahlung beim Belichten in das Trägermaterial ist, wobei die Summe der N (N ≥ 2 bis n) Teilhöhen der einzelnen Teilstrukturen der Gesamthöhe des Strukturmodells entspricht;
- e- Berechnen einer virtuellen Photomaske für jede einzelne der N (N ≥ 2 bis n) Teilstrukturen des Strukturmodells, wobei für jede der N (N ≥ 2 bis n) Photomasken die jeweiligen Topographiedaten jeder einzelnen Teilstruktur in entsprechende Werte einer individuellen Belichtungsdosis umgerechnet werden, wobei die für einen bestimmten Ort einer Teilstruktur berechnete Belichtungsdosis mit der individuellen Höhenlage desselben Ortes innerhalb der entsprechenden Teilstruktur korreliert;
- f- Positionieren einer ersten virtuellen Photomaske, die der ersten Teilstruktur in der untersten Höhenschicht des Strukturmodells entspricht, sowie von Ausrichtungsmarkierungen auf der Oberfläche des Trägermaterials;
- g- Ausgerichtetes Belichten des Trägermaterials anhand der Ausrichtungsmarkierungen, die an der Oberfläche angeordnet sind, wobei ausgehend von der Oberfläche des Trägermaterials durch ortsaufgelöstes Belichten entsprechend der in der ersten virtuellen Photomaske festgelegten individuellen Belichtungsdosis eine Strukturierung der ersten Teilstruktur in das Trägermaterial geschrieben wird;
- h- Nasschemisches Entwickeln des durch die erste virtuelle Photomaske vorgegebenen belichteten Abschnitts des Trägermaterials, wobei die Oberflächen der Strukturierung der ersten Teilstruktur in Abhängigkeit von einer Entwicklungsrate des Trägermaterials sowie von der berechneten Belichtungsdosis geglättet werden, bis die Oberflächen der Strukturierung nach dem Belichten und Entwickeln optisch glatt sind;
- i- Erhalten eines ersten Zwischenprodukts eines teilweise strukturierten Trägermaterials, wobei das erste Zwischenprodukt eine Strukturierung der ersten Teilstruktur enthält;
- j- Positionieren einer weiteren Nten (N ≥ 2 bis n) virtuellen Photomaske, wobei die Nte (N ≥ 2 bis n) virtuelle Photomaske der Nten (N ≥ 2 bis n) Teilstruktur in der der jeweils vorhergehenden (N-1) Höhenschicht sequentiell nachfolgenden, nächsthöhergelegenen Nten (N ≥ 2 bis n) Höhenschicht des Strukturmodells entspricht, innerhalb der bereits strukturierten Strukturierung der jeweils vorhergehenden (N-1) Teilstruktur des jeweils vorhergehenden (N-1) Zwischenprodukts;
- k- Ausgerichtetes weiteres Belichten des jeweils vorhergehenden (N-1) Zwischenprodukts anhand der Ausrichtungsmarkierungen, die an der Oberfläche angeordnet sind, wobei ausgehend von der bereits strukturierten Strukturierung der jeweils vorhergehenden (N-1) Teilstruktur durch ortsaufgelöstes Belichten entsprechend der in der Nten (N ≥ 2 bis n) virtuellen Photomaske festgelegten individuellen Belichtungsdosis eine Strukturierung der Nten (N ≥ 2 bis n) Teilstruktur in das jeweils vorhergehende (N-1) Zwischenprodukt eines teilweise strukturierten Trägermaterials geschrieben wird, wobei die Strukturierung der Nten (N ≥ 2 bis n) Teilstruktur innerhalb des Trägermaterials jeweils tiefer liegt als die Strukturierung der jeweils vorhergehenden (N-1) Teilstruktur;
- 1- Nasschemisches Entwickeln des durch die Nte (N ≥ 2 bis n) virtuelle Photomaske vorgegebenen belichteten Abschnitts des Trägermaterials, wobei die Oberflächen der Strukturierung der Nten (N ≥ 2 bis n) Teilstruktur in Abhängigkeit von einer Entwicklungsrate des Trägermaterials sowie von der berechneten Belichtungsdosis geglättet werden, bis die Oberflächen der Strukturierung nach dem Belichten und Entwickeln optisch glatt sind;
- m- Erforderlichenfalls entsprechendes Wiederholen einer Abfolge der Schritte -j-(Positionieren jeweils einer weiteren virtuellen Photomaske), -k- (Weiteres Belichten) und -1- (Weiteres Entwickeln), bis schichtweise sämtliche N (N ≥ 2 bis n) virtuellen Photomasken strukturiert wurden;
- n- Erhalten eines fertig strukturierten Trägermaterials, wobei das fertig strukturierte Trägermaterial eine Strukturierung entsprechend dem gesamten Strukturmodell und seiner Gesamthöhe enthält.

Unter dem Begriff einer "übergroßen Strukturhöhe" werden hier Mikrostrukturen verstanden, deren Strukturhöhen größer sind als die maximale Nenneindringtiefe der Belichtung in ein photostrukturierbares Trägermaterial.

Die maximale Nenneindringtiefe der Belichtung ergibt sich in Abhängigkeit der folgenden Parameter:
- Auswahl des eingesetzten photostrukturierbaren Trägermaterials und der jeweils möglichen Belichtungstiefen, die abhängig von den photochemischen Materialeigenschaften des gewählten Trägermaterials sind;
- Wahl der zweckmäßigen Lichtdosis, um zerstörungsfrei das Trägermaterial zu belichten;
- Wahl der verwendeten Belichtungsvorrichtung;
- Wahl der zweckmäßigen Entwicklungszeit.

In Abhängigkeit von Belichtungsparametern der gewählten Belichtungsvorrichtung wie der Entwicklungszeit sowie im Zusammenhang mit Belichtungseigenschaften bzw. Materialeigenschaften des photostrukturierbaren Trägermaterials wie der maximalen Lichtdosis, die gewählt werden kann, ohne dabei das Trägermaterial zu zerstören, ergibt sich also eine maximale Nenneindringtiefe der Belichtung, die mit den derzeitig zur Verfügung stehenden Materialien und Vorrichtungen etwa bei maximal 100 Mikrometer (µm) Nenneindringtiefe liegt.

Beispielsweise kann es zweckmäßig sein, als Belichtungsvorrichtung ein 4-fach mikroskopisches Objektiv mit einer nummerischen Apertur von 0,14 zu verwenden. Weiters kann es beispielsweise zweckmäßig sein, eine Lichtdosis von 750 mWs/cm² zu wählen, um mittels einer maskenlosen Ein-Photonen-Laserstrahllithographie (kurz: 1PL) eine Belichtungstiefe im photostrukturierbaren Trägermaterial von etwa 50 Mikrometer (µm) bei einer Lichtwellenlänge von 405 Nanometer (nm) sowie bei einer Schreibgeschwindigkeit von 100 mm/s zu erzielen. Für die Wahl der Entwicklungszeit kann es beispielsweise vorteilhaft sein, eine Entwicklungszeit von 30 min zu wählen, insbesondere wenn als Entwickler beispielsweise das Produkt AZ^{®} 2026 MIF Developer von Microchemicals (www.michrochemicals.com) eingesetzt wird.

Übergroße Strukturhöhen weisen somit im Folgenden definitionsgemäß Höhen auf, die größer sind als der genannte Richtwert von etwa 100 Mikrometer (µm) und die auch deutlich größer als dieser Richtwert sein können. Vorteilhaft lassen sich mit dem erfindungsgemäßen Verfahren auch Strukturen in das photostrukturierbare Trägermaterial aufprägen bzw. schreiben, deren Strukturhöhen beispielsweise in der Größenordnung von 500 Mikrometer (µm) oder darüber liegen können. Solche übergroßen Strukturhöhen werden im Folgenden auch als Strukturhöhen im Sub-Millimeter (mm)-Maßstab bezeichnet.

In Schritt -a- wird zuerst ein photostrukturierbares Trägermaterial flächig auf einem Substratträger aufgetragen. Vorzugsweise kann das photostrukturierbare Trägermaterial ein Photolack sein, der erforderlichenfalls in mehreren Schichten übereinander aufgetragen wird, bis eine entsprechend große Schichthöhe des flächigen Trägermaterials vorliegt, die entsprechend größer ist als die übergroßen Strukturhöhen der aufzuprägenden dreidimensionalen Mikrostruktur, die in das Trägermaterial übertragen werden sollen.

Das photostrukturierbare Trägermaterial kann dazu nach einer der folgenden gängigen Beschichtungsmethoden einfach und oder mehrfach auf dem Substratträger aufgebracht werden: Tauchbeschichtung (engl. dip coating); Schleuderbeschichtung (engl. spin coating); Schlitzdüsen-Beschichtung (engl. slot die coating); Rakel-Beschichtung (engl. doctor blading), Vorhang-Beschichtung (engl. curtain coating) oder mittels Dosierstab-Beschichtung (engl. Metering rod bzw. Meyer bar coating).

In Schritt -b- werden anhand der maximalen Nenneindringtiefe bei Belichtung des gewählten Trägermaterials sowie anhand der geometrischen Form, insbesondere von Konturdaten, der aufzuprägenden Mikrostruktur, die übergroße Strukturhöhen aufweist, entsprechende Informationen für die nachfolgende Modellierung der dreidimensionalen Mikrostruktur gesammelt.

Schritt -c- kann zweckmäßigerweise anhand von CAD-Dateien (Computer Aided Design erfolgen, die von der aufzuprägenden dreidimensionalen Mikrostruktur als virtuelles bzw. digitales dreidimensionales Strukturmodell abhängig von den zuvor ermittelten Informationen generiert werden. Das virtuelle Strukturmodell umfasst dabei Topographiedaten der abzuformenden Mikrostruktur, wobei anhand der Topographiedaten eine Gesamthöhe des Strukturmodells zu der abzuformenden Mikrostruktur bestimmt wird. Diese Gesamthöhe des Strukturmodells ist größer als die maximale Nenneindringtiefe der elektromagnetischen Strahlung beim Belichten in das Trägermaterial sowie kleiner als die aufgetragene Schichthöhe des Trägermaterials. Wie vorhin bereits festgehalten können Mikrostrukturen mit einer gesamten Strukturhöhe bzw. einer gesamten Strukturtiefe von zumindest 100 Mikrometer (µm) und darüber bis hin zu Strukturhöhen im Sub-mm-Bereich abgeformt werden. Die Strukturhöhe bzw. Strukturtiefe wird im Weiteren auf eine Z-Achsenrichtung in einem dreidimensionalen kartesischen Koordinatensystem bezogen, wobei die Z-Achsenrichtung die Höhenlage angibt.

Unter dem Begriff "Topographie" (von griechisch: tópos, "Ort", und grafeïn, "zeichnen" bzw. "beschreiben"; wörtlich "Ortsbeschreibung") wird im Weiteren die Oberflächenbeschaffenheit bzw. die Beschreibung sowohl der geometrischen Gestalt, als auch der physikalischen und chemischen Eigenschaften von technischen Oberflächen oder Mikrostrukturen verstanden. Die Beschreibung der Topografie (Oberflächenrauheit, Oberflächengestalt usw.) basiert in der Regel auf Daten von Messverfahren.

Im nächsten Schritt -d- erfolgt ein Rechnerunterstütztes Unterteilen der Gesamthöhe des dreidimensionalen Strukturmodells in eine Anzahl N (N ≥ 2 bis n), wobei die Anzahl N eine Laufvariable von N ≥ 2 bis N = n ist, von zumindest zwei oder mehr sequentiell übereinandergestapelten Höhenschichten, deren Teilhöhen jeweils kleiner oder gleich der möglichen Nenneindringtiefe der durch die Belichtungsvorrichtung lieferbaren elektromagnetischen Strahlung beim Belichten in das Trägermaterial sind, wobei die Summe der Teilhöhen der einzelnen Teilstrukturen der Gesamthöhe des Strukturmodells entspricht. Die Unterteilung in zumindest zwei oder mehrere übereinander gestapelte Höhenschichten des virtuellen Strukturmodells erfolgt in Z-Achsenrichtung entsprechend der Höhenlage eines kartesischen Koordinatensystems.

Der nächste Schritt -e-, die Berechnung einer virtuellen Photomaske für jede einzelne der Teilstrukturen des virtuellen Strukturmodells dient vorzugsweise zur Steuerung einer Vorrichtung zur maskenlosen Grauton-Lithographie. Jede virtuelle Photomaske repräsentiert somit die individuelle Belichtungsdosis bzw. die Lichtintensität für einen bestimmten Ort der Teilstruktur.

Eine maximale Strukturhöhe eines bestimmten Ortes der jeweiligen Höhenlage bzw. Teilstruktur des Strukturmodells entspricht dabei einer maximalen Tiefe, mit der dieser Ort der Teilstruktur im Trägermaterial eingeprägt bzw. eingeschrieben werden kann. Die Invertierung einer Strukturhöhe der entsprechenden Teilstruktur des Strukturmodells in eine Strukturtiefe der Strukturierung dieser Teilstruktur im Trägermaterial ergibt sich aufgrund der photochemischen Strukturierung.

Die entwickelbare Schichtdicke steigt dabei meist nichtlinear mit der Belichtungsdosis bzw. Lichtintensität pro Zeiteinheit [in mWs/cm²] an.

In weiterer Folge wird in Schritt -f- eine erste virtuelle Photomaske, die der ersten Teilstruktur in der untersten Höhenschicht des Strukturmodells entspricht, wobei in der ersten virtuellen Photomaske auch Ausrichtungsmarkierungen zum Aufprägen auf der Oberfläche des Trägermaterials hinterlegt sind, an der Oberfläche des Trägermaterials entsprechend positioniert.

Im nächsten Schritt -g- erfolgt ein ausgerichtetes Belichten des Trägermaterials anhand der Ausrichtungsmarkierungen, die an der Oberfläche des Trägermaterials angeordnet sind, wobei ausgehend von der Oberfläche des Trägermaterials durch ortsaufgelöstes Belichten entsprechend der in der ersten virtuellen Photomaske festgelegten individuellen Belichtungsdosis eine Strukturierung der ersten Teilstruktur in das Trägermaterial geschrieben wird.

Anschließend an das Belichten erfolgt in Schritt -h- das nasschemische Entwickeln des durch die erste virtuelle Photomaske vorgegebenen belichteten Abschnitts des Trägermaterials, wobei die Oberflächen der Strukturierung der ersten Teilstruktur in Abhängigkeit von einer gewählten Strukturierungsstrategie, nämlich in Abhängigkeit von der Entwicklungsrate des verwendeten Trägermaterials sowie von der berechneten Belichtungsdosis geglättet werden, bis die Oberflächen der Strukturierung nach dem Belichten und Entwickeln optisch glatt sind.

Dem Fachmann auf dem Gebiet von Abformverfahren insbesondere zur Herstellung von optischen Komponenten ist der Begriff einer "optisch glatten Oberfläche" bekannt. Wie beispielsweise dem Fachbuch "Optische Meßtechnik an technischen Oberflächen" von Alexander W. Koch et al., expert-Verlag 1998, ISBN 3-8169-1372-5, entnommen werden kann, wird eine Oberfläche dann als "optisch glatt" bezeichnet, wenn deren Oberflächenrauheit bzw. -struktur weit unterhalb der Wellenlänge λ (Lambda) des sichtbaren Spektralbereichs von Licht liegt. Es gilt für optisch hochwertige Komponenten die Forderung einer maximalen Unebenheit über eine optisch glatte Oberfläche von λ/16.

Für den sichtbaren Spektralbereich von Licht mit Wellenlängen λ von ca. 380 nm bis 780 nm bedeutet dies, dass die Rauheitswerte von "optisch glatten" Oberflächen maximal von 23,75 nm (380 nm/16) bis 48,75 nm (780 nm/16) betragen dürfen.

Das Kriterium, wonach die Oberflächen der Strukturierung, also der strukturierten Ausnehmung an der Oberseite des Trägermaterials nach dem Belichten und Entwickeln optisch glatt sein müssen, hat den Effekt, dass bei einem oder bei mehreren nachfolgenden weiteren Belichtungsschritten unerwünschte Streulichteffekte verhindert werden können. Insbesondere bei einer weiteren Laserstrukturierung ist es wichtig, die weitere Strukturierung ohne Streulichteffekte und damit einhergehende Fehlerquellen zu bewerkstelligen.

Je geringer die Rauheit der strukturierten Oberflächen, ausgedrückt als Mittenrauwert Ra, ist, umso geringere Streulichteffekte können bei der nachfolgenden, nächsten Strukturierung durch weiteres Belichten und Entwickeln der zuvor strukturierten Oberflächen auftreten. Umso exakter kann demnach auch die weitere Strukturierung mittels Belichten und Entwickeln durchgeführt werden. Vorteilhaft wird die Strukturierung der Oberflächen in der strukturierten Ausnehmung bzw. Kavität innerhalb des Trägermaterials so durchgeführt, dass Rauheitswerte für die optisch glatten Oberflächen vorzugsweise von kleiner oder gleich 30 nm (Nanometer) eingestellt werden.

Unter dem Begriff "Strukturierung" wird hier jeweils eine Kombination der Verfahrensschritte "Ausgerichtetes Belichten" (Schritt -g-) und "Nasschemisches Entwickeln" (Schritt -h-) verstanden.

Das Resultat der Strukturierung ist also eine in das Trägermaterial geschriebene Struktur, die optisch glatte Oberflächen aufweist, die für einen oder mehrere nachfolgende, weitere Strukturierungsschritte geeignet sind.

Gemäß Schritt -i- wird somit ein erstes Zwischenprodukt eines teilweise strukturierten Trägermaterials erzeugt, wobei das erste Zwischenprodukt eine Strukturierung der ersten Teilstruktur enthält.

Die weiteren Schritte -j-, -k- und -1- dienen zur Strukturierung einer nächsten virtuellen Photomaske entsprechend einer nachfolgenden, nächsten Höhenlage des virtuellen Strukturmodells innerhalb der zuvor bereits erzeugten Strukturierung.

Gemäß Schritt -m- wird eine Abfolge der Schritte -j- (Positionieren jeweils einer weiteren virtuellen Photomaske), -k- (Weiteres Belichten) und -1- (Weiteres Entwickeln) erforderlichenfalls so oft wiederholt, bis schichtweise sämtliche virtuelle Photomasken strukturiert wurden.

Gemäß Schritt -n- wird verfahrensgemäß als Produkt ein fertig strukturiertes Trägermaterial erhalten, wobei das fertig strukturierte Trägermaterial eine Strukturierung entsprechend dem gesamten virtuellen dreidimensionalen Strukturmodells entlang seiner Gesamthöhe bzw. samt seiner Gesamthöhe enthält. Das fertig strukturierte Trägermaterial kann weiters beispielsweise als Master für die weitere Abformung der Originalstruktur mit galvanischer Methoden oder zur Herstellung eines Stempels durch Silikonabformung dienen.

Mit diesem Verfahren wird ein neuartiges inverses lithographisches Verfahren zur Aufprägung von dreidimensionalen (3D)-Mikrostrukturen in ein photochemisch strukturierbares Trägermaterial angegeben, wobei die dreidimensionalen Mikrostrukturen übergroße Strukturhöhen im Mikrometer- bis hin zum Sub-Millimeter-Maßstab aufweisen, welche mit den derzeit bekannten Herstellungsverfahren bisher nicht rasch und präzise hergestellt werden konnten.

Vorteilhaft kann bei einem erfindungsgemäßen Verfahren sein, wenn das photostrukturierbare Trägermaterial ein positiv-arbeitender Photolack ist, bei dem belichtete Abschnitte beim nachfolgenden nasschemischen Entwickeln aus dem Trägermaterial herausgelöst werden.

Photolacke (engl. photoresist) werden bei der photolithographischen Strukturierung verwendet, insbesondere in der Mikroelektronik und der Mikrosystemtechnik für die Produktion von Strukturen im Mikro- und Submikrometerbereich sowie bei der Leiterplattenherstellung. Die wichtigsten Ausgangsstoffe für Photolacke sind Polymere (z. B. Polymethylmethacrylat, Polymethylglutarimid) bzw. Epoxidharze, Lösungsmittel wie Cyclopentanon oder Gamma-Butyrolacton, sowie eine fotoempfindliche Komponente.

Neben flüssigen Photolacken gibt es noch Fest- bzw. Trockenresists (Photofolien).

Beim Belichten wird die Löslichkeit der Photoschicht durch die elektromagnetische Strahlung in Form des Ultraviolett-Lichtanteils, die entsprechend der Lichtdosis der virtuellen Photomaske lokal verändert (fotochemische Reaktion).

Nach der Löslichkeitsveränderung unterscheidet man:
- Negativ-arbeitender Photolack (engl. negative tone photoresist): Die Löslichkeit nimmt durch Belichten ab
- Positiv-arbeitender Photolack (engl. positive tone photoresist): Die Löslichkeit wächst durch Belichten.

Bei positiv-arbeitenden Photolacken wird der Photolack, der gegebenenfalls bereits verfestigt ist, durch Belichtung photochemisch verändert und somit löslich für entsprechende Entwicklerlösungen und nach der Entwicklung bleiben nur die Bereiche übrig, welche durch eine entsprechende Abdeckmaske vor der Bestrahlung geschützt wurden bzw. die außerhalb der belichteten Abschnitte gelegen sind.

Der Einsatz von positiv-arbeitendem Photolack als photostrukturierbares Trägermaterial bietet den Vorteil, dass verfahrensgemäß schichtweise Höhenschicht um Höhenschicht - entsprechend den berechneten virtuellen Photomasken - immer tiefer in den Positiv-Photolack hineinstrukturiert werden kann, um schlussendlich Ausnehmungen bzw. Kavitäten im fertig strukturierten Positiv-Photolack zu erhalten, deren Gesamthöhen jenen des vorgegebenen Strukturmodells entsprechen. Nicht strukturierte Bereiche des positiv-arbeitenden Photolacks, die also nicht belichtet und entwickelt wurden, behalten vorteilhaft die anfangs gewählte Schichthöhe (gemäß Schritt -a-) bei.

Das fertig strukturierte Trägermaterial in Form eines positiv-arbeitenden Photolacks kann weiters beispielsweise als Master für die weitere Abformung der Originalstruktur mit galvanischer Methoden oder zur Herstellung eines Stempels durch Silikonabformung dienen.

Besonders vorteilhaft kann es sein, wenn bei einem erfindungsgemäßen Verfahren das ausgerichtete Belichten des Trägermaterials entweder mittels maskenloser Laserlithographie, die auf 1-Photonen- und/oder 2-Photonen-Absorption basiert, oder mittels optischer maskenloser Lithographie, wobei ein räumlicher Lichtmodulator und eine Abbildungsoptik verwendet werden, durchgeführt wird.

Unter dem Begriff "maskenlose Laserlithographie" versteht der Fachmann ein Verfahren zur Belichtung des photostrukturierbaren Trägermaterials, vorzugsweise des positiv-arbeitenden Photolacks, durch fokusierenden Laserstrahl mittels sequentieller Abtastung und gleichzeitiger Modulation der Lichtintensität. Als Belichtungsquelle wird Laserlicht verwendet. Als Vorteile dieses Belichtungsverfahrens sind zu nennen, dass mit der maskenlosen Laserlithographie eine besonders präzise definierte Lichtdosis pro Pixel, also an einem anhand der XYZ-Koordinaten exakt definierten Ort des Datensatzes. Aufgrund der Möglichkeit der Nutzung von Ein-Photonen-Absorption (kurz: 1PL) und/oder Zwei-Photonen-Absorption (kurz: 2PL) ist es mit diesem Belichtungsverfahren möglich, damit echte 3D-Strukturierungen herzustellen. Nachteilig ist dieses Belichtungsverfahren jedoch aufgrund der sequentiellen Abtastung eher langsam.

Unter dem Begriff "optische maskenlose Lithographie" versteht der Fachmann ein Verfahren zur Belichtung des photostrukturierbaren Trägermaterials, vorzugsweise des positiv-arbeitenden Photolacks, bei der die Strukturierung durch optische Abbildung einer Fläche (Pixel-Matrix) eines räumlichen Lichtmodulators auf dem Trägermaterial bzw. vorzugsweise dem Photolack erfolgt. Als Belichtungsquelle wird hierzu UV-Licht, das beispielsweise mit UV-LED's erzeugt wird, eingesetzt. Vorteilhaft ist bei diesem Belichtungsverfahren, dass die Flächenbelichtung deutlich rascher erfolgen kann als bei der maskenlosen Laserlithographie. Nachteilig am Verfahren der optischen maskenlosen Lithographie ist jedoch, dass eine echte 3D-Strukturierung mit diesem Belichtungsverfahren das Verkippen der entsprechenden Probe bzw. des Trägermaterials während der Strukturierung erforderlich machen kann. In einer bevorzugten Ausführungsvariante der Erfindung kann es insbesondere zur Strukturierung von Hinterschneidungen vorteilhaft sein, wenn zumindest eine virtuelle Photomaske anhand von Ausrichtungsmarkierungen auf der Oberfläche eines unter einem Kippwinkel gekippt angeordneten Trägermaterials positioniert wird.

Wie vorhin genannt kann es insbesondere beim Einsatz der optischen maskenlosen Lithographie als Belichtungsverfahren erforderlich sein, das Trägermaterial während der Strukturierung von echten 3D-Strukturen wie Hinterschneidungen, Unterschneidungen und/oder Überhängen zu verkippen. Der entsprechende Kippwinkel, unter dem das Trägermaterial erforderlich verkippt wird, kann beispielsweise mittels eines motorisierten Goniometers eingestellt werden.

Mit dem erfindungsgemäßen Verfahren ist es auch möglich, dass mehrere oder sämtliche virtuelle Photomasken auf der Oberfläche eines unter einem Kippwinkel gekippt angeordneten Trägermaterials positioniert werden. Weiters ist es im Rahmen des erfindungsgemäßen Verfahrens vorgesehen, dass zur Belichtung das Trägermaterial für mehrere oder für sämtliche virtuelle Photomasken jeweils unter demselben Kippwinkel oder aber unter individuellen, unterschiedlichen Kippwinkeln je zu strukturierender Höhenschicht bzw. je virtueller Photomaske gekippt werden kann.

In einer Weiterbildung dieser vorteilhaften Verfahrensvariante kann das ausgerichtete Belichten des Trägermaterials sowie das nachfolgende nasschemische Entwickeln des durch die zumindest eine virtuelle Photomaske vorgegebenen belichteten Abschnitts des Trägermaterials anhand von Ausrichtungsmarkierungen auf der Oberfläche eines unter einem Kippwinkel gekippt angeordneten Trägermaterials erfolgen.

Die Ausrichtungsmarkierungen, die gemeinsam mit der ersten virtuellen Photomaske an der Oberfläche des Trägermaterials mitstrukturiert werden, dienen auch bei verkippter Belichtung bzw. verkippter Strukturierung des Trägermaterials dazu, präzise die weiteren, nachfolgenden Strukturierungsschritte zu positionieren.

Besonders zweckmäßig kann es sein, wenn beim erfindungsgemäßen Verfahren das photostrukturierbare Trägermaterial eine Schichthöhe größer als 100 Mikrometer (µm), vorzugsweise größer als 200 Mikrometer (µm), besonders bevorzugt größer als 500 Mikrometer (µm), aufweist, wobei das Trägermaterial vorzugsweise mehrlagig auf dem Substratträger aufgebracht wird.

Die Schichthöhe des Trägermaterials sollte dabei so gewählt werden, dass das Trägermaterial eine ausreichende Schichtdicke zur Aufnahme des gesamten Strukturmodells, insbesondere der Gesamthöhe des Strukturmodells, bietet.

Vorteilhaft kann beim erfindungsgemäßen Verfahren die Gesamthöhe des Strukturmodells größer als 100 Mikrometer (µm) sein.

Vorteilhaft lassen sich mit dem erfindungsgemäßen Verfahren dreidimensionale Mikrostrukturen mit übergroße Strukturhöhen im Mikrometer- bis hin zum Sub-Millimeter-Maßstab herstellen, welche mit den derzeit bekannten Herstellungsverfahren bisher nicht rasch und präzise hergestellt werden konnten. Die Gesamthöhe des Strukturmodells, das in Schritt -c- modelliert wird, kann daher auch deutlich größer als 100 Mikrometer (µm) sein und bis zum Sub-Millimeter-Maßstab reichen.

In einer weiteren vorteilhaften Variante der Erfindung kann beim Verfahren die Anzahl N (N ≥ 2 bis n) so ausgewählt werden, dass jede der N (N ≥ 2 bis n) Teilhöhen der einzelnen Teilstrukturen kleiner oder gleich einer maximalen Nenneindringtiefe ist, vorzugsweise kleiner ist als 30 Mikrometer (µm), besonders bevorzugt kleiner ist als 20 Mikrometer (µm).

Wie vorhin bereits erwähnt wird die maximale Nenneindringtiefe bei der Belichtung maßgeblich durch eine Kombination der folgenden Faktoren bestimmt:
- die maximal mögliche Lichtdosis, ohne das Trägermaterial zu zerstören;
- die maximale Entwicklungszeit;
- die photochemischen Materialeigenschaften des verwendeten Trägermaterials.

Aufgrund dieser Faktoren hat sich in Vorversuchen gezeigt, dass je nach Anwendungsfall eine präzise Strukturierung des Trägermaterials möglich sein kann, wenn beispielsweise die Teilhöhen der Teilstrukturen kleiner oder gleich 50 Mikrometer (µm) gewählt werden. Je kleiner die Teilhöhen der Teilstrukturen gewählt werden, umso exakter können auch komplexe Strukturmodelle, also Strukturmodelle mit komplexer geometrischer Formgebung, die beispielsweise Hinterschneidungen umfassen, verfahrensgemäß in das Trägermaterial geschrieben werden.

Besonders zweckmäßig kann es sein, wenn bei einem erfindungsgemäßen Verfahren die Anzahl N (N ≥ 2 bis n) so ausgewählt wird, dass jede der N (N ≥ 2 bis n) Teilhöhen der einzelnen Teilstrukturen dieselbe Teilhöhe aufweist, welche Teilhöhe kleiner oder gleich einer maximalen Nenneindringtiefe ist, vorzugsweise kleiner ist als 30 Mikrometer (µm), besonders bevorzugt kleiner ist als 20 Mikrometer (µm).

In dieser Variante kann effizient immer mit derselben Teilhöhe jeder Teilstruktur gearbeitet werden.

Besonders präzise Strukturierungen können erzielt werden, wenn bei einem erfindungsgemäßen Verfahren die optisch glatten Oberflächen der Teilstrukturen nach dem Belichten und Entwickeln eine Rauheit mit einem Mittenrauwert Ra von höchstens 50 Nanometer (nm), bevorzugt von höchstens 40 Nanometer (nm), besonders bevorzugt von höchstens 30 Nanometer (nm), aufweisen.

Insbesondere bei einer weiteren Laserstrukturierung bieten optisch glatte Oberflächen den Vorteil, die nachfolgende, weitere Strukturierung ohne Streulichteffekte und damit ohne damit einhergehende Fehlerquellen zu bewerkstelligen.

Weitere Einzelheiten, Merkmale und Vorteile der Erfindung ergeben sich aus der nachfolgenden Erläuterung von in den Zeichnungen schematisch dargestellten Ausführungsbeispielen. In den Zeichnungen zeigen jeweils in Seitenansichten:
- **Fig.1** ein photostrukturierbares Trägermaterial, das in einer Schichthöhe auf einem Substratträger aufgetragen ist;
- **Fig. 2** ein dreidimensionales Strukturmodell einer Mikrostruktur gemäß einer ersten Ausführungsvariante, die in das Trägermaterial übertragen werden soll;
- **Fig. 3** das in Fig. 2 gezeigte Strukturmodell nach dem Unterteilen in mehrere Teilstrukturen entsprechend einer Sequenz mehrerer übereinandergestapelter Höhenschichten;
- **Fig. 4** mehrere virtuelle Photomasken, die den Topographiedaten der einzelnen Teilstrukturen bzw. Höhenschichten des Strukturmodells entsprechen;
- **Fig. 5** in vereinfachter Diagrammform die Korrelation der jeweiligen Belichtungsdosis jeder virtuellen Photomaske mit den Topographiedaten jeder einzelnen Teilstruktur;
- **Fig. 6** das Positionieren einer ersten virtuellen Photomaske, die der ersten Teilstruktur der untersten Höhenschicht des Strukturmodells entspricht, gemeinsam mit Ausrichtungsmarkierungen an der Oberfläche des Trägermaterials;
- **Fig. 7** nach dem Belichten und Entwickeln des Trägermaterials anhand der ersten virtuellen Photomaske das Positionieren einer weiteren, zweiten virtuellen Photomaske, die der zweiten Teilstruktur der der untersten Höhenschicht sequentiell folgenden, nächsthöheren Höhenschicht des Strukturmodells entspricht, innerhalb der bereits strukturierten Strukturierung der ersten Teilstruktur;
- **Fig. 8** nach dem Belichten und Entwickeln des Trägermaterials anhand der ersten und zweiten virtuellen Photomaske das Positionieren einer weiteren, dritten virtuellen Photomaske innerhalb der zuvor bereits hergestellten Strukturierung;
- **Fig. 9** ein fertig strukturiertes Trägermaterial mit einer Strukturierung des gesamten in Fig. 2 gezeigten Strukturmodells;
- **Fig. 10** das Positionieren einer ersten virtuellen Photomaske, die der ersten Teilstruktur der untersten Höhenschicht eines Strukturmodells einer Mikrostruktur gemäß einer zweiten Ausführungsvariante entspricht, gemeinsam mit Ausrichtungsmarkierungen an der Oberfläche des Trägermaterials;
- **Fig. 11** nach dem Belichten und Entwickeln des Trägermaterials anhand der ersten virtuellen Photomaske das Positionieren einer weiteren, zweiten virtuellen Photomaske, die der zweiten Teilstruktur der der untersten Höhenschicht sequentiell folgenden, nächsthöheren Höhenschicht des Strukturmodells entspricht, in einer unter einem Kippwinkel gekippten Lage innerhalb der bereits strukturierten Strukturierung der ersten Teilstruktur;
- **Fig. 12** ein fertig strukturiertes Trägermaterial mit einer Strukturierung eines Strukturmodells mit einem Überhang.

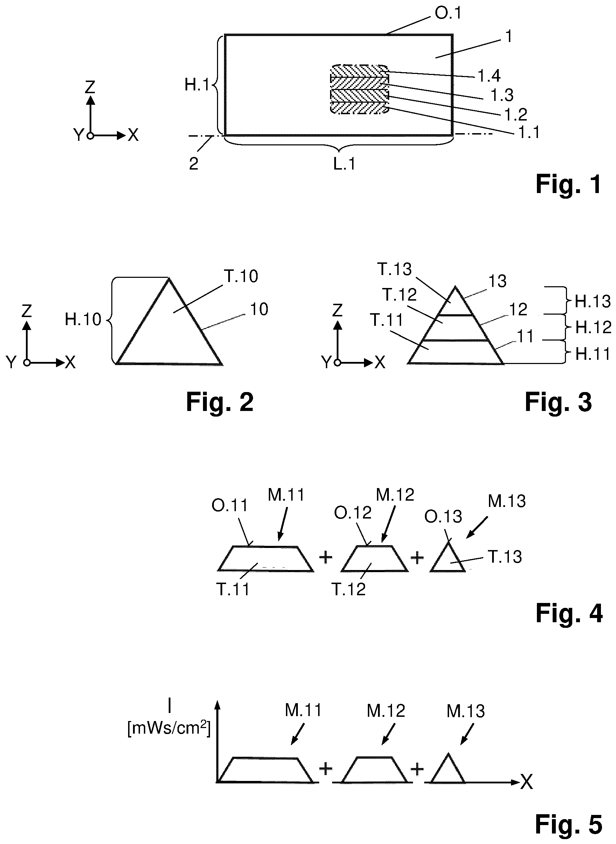

In der folgenden detaillierten Figurenbeschreibung wird im Folgenden auf die Abbildungen **Fig. 1** bis **Fig. 9** Bezug genommen, die eine erste Ausführungsvariante des erfindungsgemäßen Verfahrens betreffen.

**Fig.1** zeigt schematisch ein photostrukturierbares Trägermaterial 1, beispielsweise einen positiv-arbeitenden Photolack, das in mehreren flächigen Lagen 1.1, 1.2, 1.3,1.4 in einer gesamten Schichthöhe H.1 auf einem Substratträger 2 aufgetragen ist. Als Substratträger 2 dient hier beispielsweise eine ebene Glasplatte. Die mehreren Lagen 1.1,1.2,1.3,1.4, aus denen das Trägermaterial 1 aufgetragen ist, sind in einer teilweisen Schnittansicht in Fig. 1 symbolisiert. Tatsächlich ist es wichtig, dass sich die mehreren Lagen 1.1, 1.2, 1.3, 1.4 des positiv-arbeitenden Photolacks möglichst homogen miteinander verbinden, um ein homogen strukturiertes Trägermaterial 1 mit großer Schichthöhe H.1 zu erhalten, das möglichst an jedem Ort dieselben photochemischen Materialeigenschaften aufweist. Die Schichthöhe H.1 bzw. Schichtdicke des Trägermaterials 1 bzw. Photolacks wird hier beispielsweise mit 900 µm (Mikrometer) gewählt. In einem kartesischen Koordinatensystem entspricht die Höhenrichtung der Schichthöhe H.1 der Z-Achsenrichtung. Das Trägermaterial 1 hat eine ebene Oberfläche O.1 bzw. Außenfläche, die sich in Richtung der X-Y-Ebene erstreckt.

Als positiv-arbeitender Photolack können hier beispielsweise wahlweise das Produkt AZ^{®} 4562 ("Positive thick resist") oder das Produkt AZ^{®} 9260, beide von Microchemicals (www.microchemichals.com), eingesetzt werden. Eine maximale Nenneindringtiefe der Belichtung beträgt bei diesen Photolacken etwa 75 Mikrometer (µm).

**Fig. 2** zeigt in einer Seitenansicht ein digital erzeugtes, virtuelles dreidimensionales Strukturmodell 10 einer dreidimensionalen Mikrostruktur, die in das Trägermaterial 1 übertragen werden soll. Das Strukturmodell 10 umfasst die Topographiedaten T.10 der abzuformenden Mikrostruktur. Das Strukturmodell 10 weist eine Gesamthöhe H.10 auf, die der maximalen Erstreckung des Strukturmodells 10 in Z-Achsenrichtung entspricht. Die Gesamthöhe H.10 des Strukturmodells 10 beträgt hier beispielsweise 400 µm (Mikrometer) und ist damit größer als die maximale Nenneindringtiefe der elektromagnetischen Strahlung beim Belichten des Trägermaterials (rund 75 µm) und kleiner als die aufgetragene Schichthöhe H.1 hier von 900 µm des Trägermaterials 1 auf dem Substratträger 2.

**Fig. 3** stellt das in Fig. 2 gezeigte virtuelle dreidimensionale Strukturmodell 10 nach dem rechnerunterstützten Unterteilen in mehrere Teilstrukturen 11, 12, 13 entsprechend einer Sequenz mehrerer übereinandergestapelter Höhenschichten dar. Jede Teilstruktur 11, 12, 13 hat eine Teilhöhe H.11, H.12, H.13, wobei jede der Teilhöhen H.11, H.12, H.13 kleiner oder gleich der möglichen Nenneindringtiefe bei Belichtung des Trägermaterials 1 ist.

Hier wird beispielsweise für jede Teilstruktur 11, 12,13 jeweils dieselbe Teilhöhe H.11, H.12, H.13 gewählt, die hier beispielsweise 40 µm beträgt und somit kleiner als die Nenneindringtiefe bei Belichtung des Trägermaterials 1 ist. Tatsächlich muss im hier beispielhaft genannten Fall die Gesamthöhe H.10 von 400 µm auf 10 übereinander gestapelte Teilstrukturen 11, 12, 13, usw. aufgeteilt werden, wobei jede der Teilstrukturen hier dieselbe Teilhöhe H.11, H.12, H.13, usw. beispielsweise jeweils von 40 µm aufweist. Jede Teilstruktur 11, 12, 13 weist die zugehörigen Topographiedaten T.11, T.12, T.13 auf. Der Einfachheit halber beschränkt sich die Darstellung in den folgenden schematischen Abbildungen jedoch auf die gezeigten drei übereinander gestapelten Teilstrukturen 11, 12, 13. Dem Fachmann ist es jedoch geläufig, je nach Anforderung entsprechende virtuelle Strukturmodelle 10 erforderlichenfalls auch in eine Vielzahl von Teilstrukturen gegebenenfalls mit unterschiedlichen Teilhöhen zu unterteilen.

**Fig. 4** zeigt mehrere virtuelle Photomasken M.11, M.12, M.13, die für jede einzelne der Teilstrukturen 11, 12, 13 des Strukturmodells 10 berechnet werden. Dazu werden die jeweiligen Topographiedaten T.11, T.12, T.13 der einzelnen Teilstrukturen 11, 12, 13 bzw. Höhenschichten des Strukturmodells 10 in entsprechende Werte einer individuellen Belichtungsdosis umgerechnet. Die mit O.11, O.12 und O.13 bezeichneten Oberseiten der Teilstrukturen 11, 12, 13 dienen hier bloß der eindeutigen Zuordnung, wie die einzelnen Teilstrukturen 11, 12, 13 übereinandergestapelt werden, um insgesamt das gesamte Strukturmodell 10 zu bilden. Die in Fig. 4 schematisch dargestellten Photomasken M.11, M.12, M.13 korrelieren mit den Topographiedaten T.11, T.12, T.13 der einzelnen Teilstrukturen 11, 12, 13 insofern, als dass die für einen bestimmten Ort X,Y,Z einer Teilstruktur 11, 12, 13 berechnete individuelle Belichtungsdosis mit der zugehörigen individuellen Höhenlage bzw. mit dem Koordinatenwert in Z-Achsenrichtung desselben Ortspunktes X,Y,Z innerhalb dieser Teilstruktur 11, 12, 13 zusammenhängt.

**Fig. 5** zeigt in einer vereinfachten Diagrammform die Korrelation der jeweiligen Belichtungsdosis I (in mWs/cm²) jeder virtuellen Photomaske M.11, M.12, M13 mit den Topographiedaten jeder einzelnen Teilstruktur 11, 12, 13. Je größer die lokale Belichtungsdosis I gewählt wird, umso höher liegende Orte X,Y,Z innerhalb einer Teilstruktur 11, 12, 13, wobei sich die Höhenlage der Orte auf deren Lage im Strukturmodell 10 bezieht, können bei der anschließenden Strukturierung mittels der virtuellen Photomasken M.11, M.12, M.13 umso tiefer in das Trägermaterial 1 geschrieben werden. Bezogen auf das Trägermaterial 1 bedeutet eine höhere Belichtungsdosis I also, dass umso tiefer in das Trägermaterial 1 geschrieben werden kann.

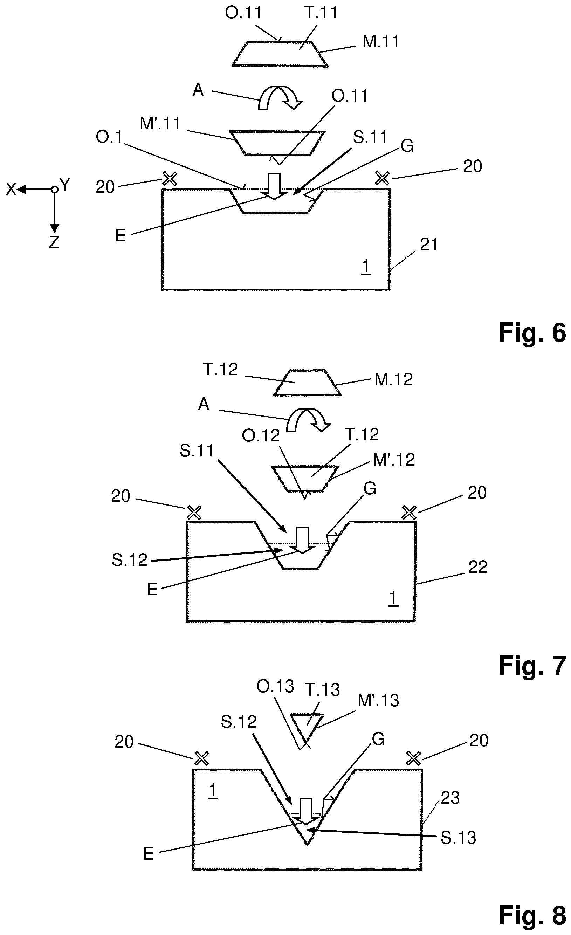

**Fig. 6** zeigt das Positionieren einer ersten virtuellen Photomaske M.11, die der ersten Teilstruktur 11 der untersten Höhenschicht des Strukturmodells 10 entspricht, gemeinsam mit Ausrichtungsmarkierungen 20 an der Oberfläche O.1 des Trägermaterials 1 bzw. des positiv-arbeitenden Photolacks. Das Positionieren der Photomaske M.11 ist hier durch einen Pfeil A symbolisiert. Die Ausrichtungsmarkierungen 20, anhand der auch die nachfolgenden Verfahrensschritte ausgerichtet werden, sind in der ersten virtuellen Photomaske M.11 enthalten und werden mit dieser mitstrukturiert.

Zur Verdeutlichung der Wirkungsweise der photochemischen Strukturierung, die das ausgerichtete Belichten des durch die erste virtuelle Photomaske M.11 vorgegebenen belichteten Abschnitt des Trägermaterials 1 sowie das anschließende nasschemische Entwickeln umfasst, und die durch den Pfeil E symbolisiert ist, ist hier in Fig. 6 auch eine invertierte erste virtuelle Photomaske M'.11 dargestellt. Die invertierte erste virtuelle Photomaske M'.11 entspricht der ersten virtuellen Photomaske M.11, jedoch mit geänderter bzw. invertierter Polarität.

Die Invertierung einer Strukturhöhe H.11 (in "positive" Z-Achsenrichtung gemäß Fig. 3) der entsprechenden ersten Teilstruktur 11 des Strukturmodells 10 in eine Strukturtiefe der Strukturierung S.11 dieser Teilstruktur 11 im Trägermaterial 1 (in "negative" Z-Achsenrichtung gemäß Fig. 6) ergibt sich aufgrund der photochemischen Strukturierung. Die Strukturierungsparameter werden dabei so gewählt, dass die Oberflächen der Strukturierung S.11 nach dem Strukturieren E, als nach dem Belichten und Entwickeln, optisch glatt G sind. Mit Position 21 wird das erste Zwischenprodukt 21 des strukturierten Trägermaterials 1 bezeichnet, das mit der Strukturierung S.11 entsprechend der ersten Teilstruktur 11 strukturiert ist.

**Fig. 7** veranschaulicht nach dem Belichten und Entwickeln E des Trägermaterials 1 anhand der ersten virtuellen Photomaske M. 11 das Positionieren einer weiteren, zweiten virtuellen Photomaske M.12, die der zweiten Teilstruktur 12 der der untersten Höhenschicht sequentiell folgenden, nächsthöheren Höhenschicht des Strukturmodells 10 entspricht, innerhalb der bereits strukturierten Strukturierung S.11 der ersten Teilstruktur 11.

Abermals wird die zweite virtuelle Photomaske M.12 anhand der Ausrichtungsmarkierungen 20 an der Oberfläche O.1 des Trägermaterials 1 positioniert, was durch Pfeil A symbolisiert ist.

Die weitere Strukturierung, die das ausgerichtete Belichten des durch die zweite virtuelle Photomaske M.12 vorgegebenen belichteten Abschnitt des Trägermaterials 1 sowie das anschließende nasschemische Entwickeln umfasst, ist durch den Pfeil E symbolisiert.

Vergleichbar mit Fig. 7 ist auch hier in Fig. 7 eine invertierte zweite virtuelle Photomaske M'.12 dargestellt. Die invertierte zweite virtuelle Photomaske M'.12 entspricht wiederum der zweiten virtuellen Photomaske M.12, jedoch mit geänderter bzw. invertierter Polarität.

Die Invertierung der Strukturhöhe H.12 (in "positive" Z-Achsenrichtung gemäß Fig. 3) der entsprechenden zweiten Teilstruktur 12 des Strukturmodells 10 in eine Strukturtiefe der Strukturierung S.12 dieser Teilstruktur 12 im Trägermaterial 1 (in "negative" Z-Achsenrichtung gemäß Fig. 7) ergibt sich abermals aufgrund der photochemischen Strukturierung. Die Strukturierungsparameter werden dabei so gewählt, dass auch die Oberflächen der Strukturierung S.12, die innerhalb bzw. unterhalb der zuvor strukturierten Kavität S.11 angeordnet wird, nach dem Strukturieren E, als nach dem Belichten und Entwickeln, optisch glatt G sind. Mit Position 22 wird das zweite Zwischenprodukt 22 des strukturierten Trägermaterials 1 bezeichnet, das zusätzlich mit der Strukturierung S.12 entsprechend der zweiten Teilstruktur 12 strukturiert ist.

**Fig. 8** stellt eine Wiederholung der zuvor bereits in Fig. 6 und Fig. 7 gezeigten Strukturierungsschritte dar und zeigt nach dem zuvor durchgeführten Strukturieren E, also dem Belichten und Entwickeln des Trägermaterials 1, anhand der ersten M.11 und zweiten virtuellen Photomaske M.12 das Positionieren einer weiteren, dritten virtuellen Photomaske M.13 innerhalb der zuvor bereits hergestellten Strukturierung S.12.

Die hier dargestellte invertierte dritte virtuelle Photomaske M'.13 entspricht wiederum der dritten virtuellen Photomaske M.13, wie diese beispielsweise in Fig. 5 veranschaulicht ist, jedoch mit geänderter bzw. invertierter Polarität.

Die weitere Strukturierung, die das ausgerichtete Belichten des durch die dritte virtuelle Photomaske M.13 vorgegebenen belichteten Abschnitt des Trägermaterials 1 sowie das anschließende nasschemische Entwickeln umfasst, ist wieder durch den Pfeil E symbolisiert.

Die Strukturierungsparameter werden dabei so gewählt, dass auch die Oberflächen der Strukturierung S.13, die innerhalb bzw. unterhalb der zuvor strukturierten Kavität S.12 angeordnet wird, nach dem Strukturieren E, als nach dem Belichten und Entwickeln, optisch glatt G sind. Mit Position 23 wird das dritte Zwischenprodukt 23 des strukturierten Trägermaterials 1 bezeichnet, das zusätzlich bereits mit der Strukturierung S.13 entsprechend der dritten Teilstruktur 13 strukturiert ist.

Durch entsprechende Wiederholung des Positionierens weiterer virtueller Photomasken, anhand derer die weitere schichtweise Strukturierung E erfolgt, werden schichtweise sämtliche Teilstrukturen immer tiefer in das Trägermaterial 1 strukturiert, bis das Trägermaterial 1 schließlich die Strukturierung des gesamten Strukturmodells S.10 entsprechend seiner Gesamthöhe H.10 enthält.

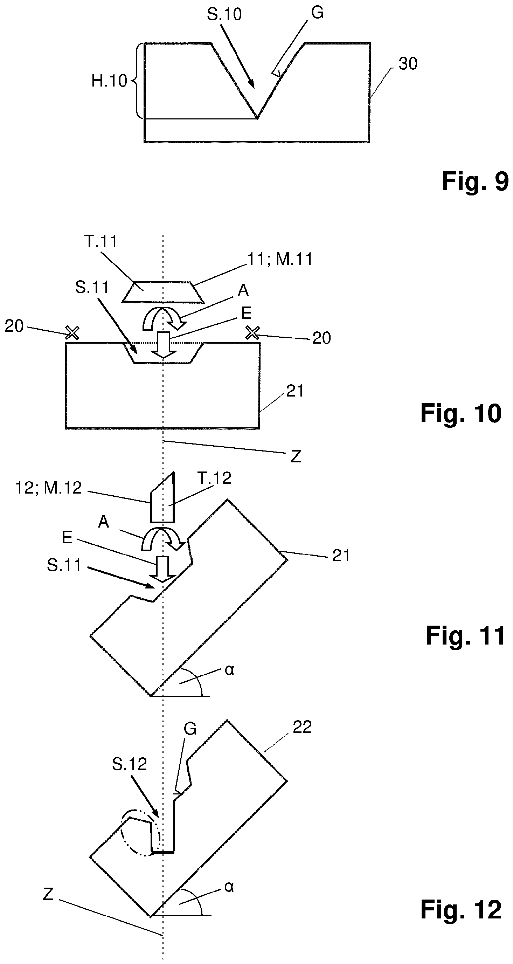

**Fig. 9** zeigt in einer Seitenansicht als Produkt des Herstellungsverfahrens ein fertig strukturiertes Trägermaterial 30 mit einer Strukturierung des gesamten in Fig. 2 gezeigten Strukturmodells 10.

Die weiteren Abbildungen **Fig. 10** bis **Fig. 12** betreffen eine weitere Ausführungsvariante des erfindungsgemäßen Verfahrens, die sich gegenüber der zuvor beschriebenen Variante im Wesentlichen nur durch das Verkippen des Trägermaterials 1 zur Strukturierung von Hinterschneidungen unterscheidet. Für vergleichbare Verfahrensmerkmale werden jeweils gleiche Positionsbezeichnungen verwendet. Es wird dazu auf die vorige detaillierte Erläuterung verwiesen.

**Fig. 10** zeigt - vergleichbar mit Fig. 6 - das Positionieren einer ersten virtuellen Photomaske M.11, die der ersten Teilstruktur 11 der untersten Höhenschicht eines Strukturmodells 10 einer Mikrostruktur gemäß einer zweiten Ausführungsvariante entspricht, gemeinsam mit Ausrichtungsmarkierungen 20 an der Oberfläche des Trägermaterials 1.

**Fig. 11** zeigt nach dem Strukturieren E, also dem Belichten und Entwickeln des Trägermaterials 1, entsprechend der ersten virtuellen Photomaske M.11 das Positionieren einer weiteren, zweiten virtuellen Photomaske M.12, die der zweiten Teilstruktur 12 der der untersten Höhenschicht sequentiell folgenden, nächsthöheren Höhenschicht des Strukturmodells 10 entspricht, in einer unter einem Kippwinkel α gekippten Lage innerhalb der bereits zuvor hergestellten Strukturierung S.11 der ersten Teilstruktur 11. Der Kippwinkel α, unter dem das Trägermaterial 1 bzw. hier das erste Zwischenprodukt 21 des strukturierten Trägermaterials 1 gekippt wird, wird in Bezug auf die Waagrechte, also die X-Y-Ebene im kartesischen Koordinatensystem, angegeben.

**Fig. 12** zeigt ein zweites Zwischenprodukt 22, in dem bereits die weitere zweite Strukturierung S.12 hergestellt ist, die eine dreidimensionale Hinterschneidung bzw. einen Überhang der Strukturierung bildet. Der Abschnitt der Hinterschneidung ist in Fig. 12 mit einer Strichzweipunktlinie gekennzeichnet. Gegebenenfalls kann so durch entsprechende Wiederholung weiterer Strukturierungsschritte ein fertig strukturiertes Trägermaterial mit einer Strukturierung eines Strukturmodells mit einem Überhang hergestellt werden.

### LISTE DER BEZUGSZEICHEN

- 1: Photostrukturierbares Trägermaterial, Photolack
- 1.1: Lage des Trägermaterials (bzw. weitere Lagen 1.2, 1.3, 1.4)
- 2: Substratträger
- 10: Strukturmodell
- 11: erste Teilstruktur des Strukturmodells
- 12: zweite Teilstruktur des Strukturmodells
- 13: dritte Teilstruktur des Strukturmodells
- 20: Ausrichtungsmarkierung
- 21: erstes Zwischenprodukt des strukturierten Trägermaterials
- 22: zweites Zwischenprodukt des weiter strukturierten Trägermaterials
- 23: drittes Zwischenprodukt des strukturierten Trägermaterials
- 30: strukturiertes Trägermaterial
- A: Positionieren der virtuellen Photomaske (Pfeil)
- E: Belichten und Entwickeln (Pfeil)
- G: optisch glatte Oberfläche
- H.1: Schichthöhe des Trägermaterials
- H.10: Gesamthöhe des Strukturmodells
- H.11: Teilhöhe der ersten Teilstruktur des Strukturmodells
- H.12: Teilhöhe der zweiten Teilstruktur des Strukturmodells
- H.13: Teilhöhe der dritten Teilstruktur des Strukturmodells
- L.1: Länge des Trägermaterials
- M.11: erste virtuelle Photomaske der ersten Teilstruktur des Strukturmodells
- M.12: zweite virtuelle Photomaske der zweiten Teilstruktur des Strukturmodells
- M.13: dritte virtuelle Photomaske der dritten Teilstruktur des Strukturmodells
- M'.11: invertierte erste virtuelle Photomaske (mit geänderter Polarität)
- M'.12: invertierte zweite virtuelle Photomaske (mit geänderter Polarität)
- M'.13: invertierte dritte virtuelle Photomaske (mit geänderter Polarität)
- O.1: Oberfläche bzw. Außenfläche des Trägermaterials
- O.11: Oberseite der ersten virtuellen Photomaske
- O.12: Oberseite der zweiten virtuellen Photomaske
- O.13: Oberseite der dritten virtuellen Photomaske

### LISTE DER BEZUGSZEICHEN (FORTSETZUNG)

- S.10: Strukturierung des gesamten Strukturmodells
- S.11: Strukturierung der ersten Teilstruktur des Strukturmodells
- S.12: Strukturierung der zweiten Teilstruktur des Strukturmodells
- S.13: Strukturierung der dritten Teilstruktur des Strukturmodells
- T.10: Topographiedaten des gesamten Strukturmodells
- T.11: Topographiedaten der ersten Teilstruktur
- T.12: Topographiedaten der zweiten Teilstruktur
- T.13: Topographiedaten der dritten Teilstruktur
- X: X-Achsenrichtung
- Y: Y-Achsenrichtung
- Z: Z-Achsenrichtung
- α: Kippwinkel

## Patentansprüche

1. Lithographisches Verfahren zur Aufprägung von dreidimensionalen Mikrostrukturen, welche übergroße Strukturhöhen aufweisen, in ein photostrukturierbares Trägermaterial unter Verwendung einer Belichtungsvorrichtung, wobei in Abhängigkeit von Belichtungsparamatern der Belichtungsvorrichtung im Zusammenhang mit Belichtungseigenschaften des photostrukturierbaren Trägermaterials eine maximale Nenneindringtiefe der Belichtung und damit eine resultierende Photostrukturierung des Trägermaterials einhergeht und eine übergroße Strukturhöhe eine Höhe aufweist, die den Wert der maximalen Nenneindringtiefe überschreitet, wobei das Verfahren die folgenden Verfahrensschritte umfasst:
- a- Flächiges Auftragen eines photostrukturierbaren Trägermaterials (1) auf einem Substratträger (2), wobei das aufgetragene Trägermaterial (1) eine Schichthöhe (H.1) aufweist sowie eine plane Oberfläche (O.1) auf der dem Substratträger (2) gegenüberliegenden Oberseite hat, und wobei die Eigenschaften des Trägermaterials (1) durch Belichten mit elektromagnetischer Strahlung veränderbar sind;
- b- Heranziehen von Informationsdaten als Eingangsgröße, wobei diese Informationsdaten Angaben zur maximalen Nenneindringtiefe des gewählten photostrukturierbaren Trägermaterials (1) sowie zur geometrischen Form einer aufzuprägenden dreidimensionalen Mikrostruktur aufweisend eine übergroße Strukturhöhe enthalten;
- c- Rechnerunterstütztes Modellieren eines virtuellen dreidimensionalen Strukturmodells (10) der aufzuprägenden Mikrostruktur in Abhängigkeit von den Informationsdaten gemäß Schritt -b-, wobei das Strukturmodell (10) Topographiedaten (T.10) der abzuformenden Mikrostruktur umfasst und anhand der Topographiedaten (T.10) eine Gesamthöhe (H.10) des Strukturmodells (10) zu der abzuformenden Mikrostruktur bestimmt wird, welche Gesamthöhe (H.10) größer als die maximale Nenneindringtiefe der elektromagnetischen Strahlung beim Belichten in das Trägermaterial (1) sowie kleiner als die aufgetragene Schichthöhe (H.1) des Trägermaterials (1) ist;
- d- Rechnerunterstütztes Unterteilen der Gesamthöhe (H.10) des dreidimensionalen Strukturmodells (10) in eine Anzahl N (N ≥ 2 bis n) von sequentiell übereinandergestapelten Höhenschichten, wobei jede der N (N ≥ 2 bis n) Höhenschichten einer einzelnen Teilstruktur (11, 12, 13, ) des Strukturmodells (10) entspricht, und wobei jede einzelne der N (N ≥ 2 bis n) Teilstrukturen (11, 12, 13, ) jeweils eine Teilhöhe (H.11, H.12, H.13, ) hat, wobei die Anzahl N eine ganze Zahl ist, welche größer oder gleich der Zahl 2 ist, und wobei die Anzahl N (N ≥ 2 bis n) so ausgewählt wird, dass jede der N (N ≥ 2 bis n) Teilhöhen (H.11, H.12, H.13, ) kleiner oder gleich der möglichen Nenneindringtiefe der durch die Belichtungsvorrichtung lieferbaren elektromagnetischen Strahlung beim Belichten in das Trägermaterial (1) ist, wobei die Summe der N (N ≥ 2 bis n) Teilhöhen (H.11, H.12, H.13, ) der einzelnen Teilstrukturen (11, 12, 13, ) der Gesamthöhe (H.10) des Strukturmodells (10) entspricht;
- e- Berechnen einer virtuellen Photomaske (M.11, M.12, M.13, ) für jede einzelne der N (N ≥ 2 bis n) Teilstrukturen (11, 12,13, ) des Strukturmodells (10), wobei für jede der N (N ≥ 2 bis n) Photomasken (M.11, M.12, M.13, ) die jeweiligen Topographiedaten (T.11, T.12, T.13, ) jeder einzelnen Teilstruktur (11, 12, 13, ) in entsprechende Werte einer individuellen Belichtungsdosis umgerechnet werden, wobei die für einen bestimmten Ort (X, Y, Z) einer Teilstruktur (11, 12, 13, ) berechnete Belichtungsdosis mit der individuellen Höhenlage (Z) desselben Ortes (X, Y, Z) innerhalb der entsprechenden Teilstruktur (11, 12, 13, ) korreliert;
- f- Positionieren einer ersten virtuellen Photomaske (M.11), die der ersten Teilstruktur (11) in der untersten Höhenschicht des Strukturmodells (10) entspricht, sowie von Ausrichtungsmarkierungen (20) auf der Oberfläche (O.1) des Trägermaterials (1);
- g- Ausgerichtetes Belichten des Trägermaterials (1) anhand der Ausrichtungsmarkierungen (20), die an der Oberfläche (O.1) angeordnet sind, wobei ausgehend von der Oberfläche (O.1) des Trägermaterials (1) durch ortsaufgelöstes (X, Y, Z) Belichten entsprechend der in der ersten virtuellen Photomaske (M.11) festgelegten individuellen Belichtungsdosis eine Strukturierung (S.11) der ersten Teilstruktur (11) in das Trägermaterial (1) geschrieben wird;
- h- Nasschemisches Entwickeln (E) des durch die erste virtuelle Photomaske (M.11) vorgegebenen belichteten Abschnitts des Trägermaterials (1), wobei die Oberflächen der Strukturierung (S.11) der ersten Teilstruktur (11) in Abhängigkeit von einer Entwicklungsrate des Trägermaterials (1) sowie von der berechneten Belichtungsdosis geglättet werden, bis die Oberflächen der Strukturierung (S.11) nach dem Belichten und Entwickeln (E) optisch glatt (G) sind;
- i- Erhalten eines ersten Zwischenprodukts (21) eines teilweise strukturierten Trägermaterials, wobei das erste Zwischenprodukt (21) eine Strukturierung (S.11) der ersten Teilstruktur (11) enthält;
- j- Positionieren einer weiteren Nten (N ≥ 2 bis n) virtuellen Photomaske (M.12, M.13,), wobei die Nte (N ≥ 2 bis n) virtuelle Photomaske (M.12, M.13, ) der Nten (N ≥ 2 bis n) Teilstruktur (12, 13, ) in der der jeweils vorhergehenden (N-1) Höhenschicht sequentiell nachfolgenden, nächsthöhergelegenen Nten (N ≥ 2 bis n) Höhenschicht des Strukturmodells (10) entspricht, innerhalb der bereits strukturierten Strukturierung (S.11) der jeweils vorhergehenden (N-1) Teilstruktur (11) des jeweils vorhergehenden (N-1) Zwischenprodukts (21);
- k- Ausgerichtetes weiteres Belichten des jeweils vorhergehenden (N-1) Zwischenprodukts (21, 22, 23, ) anhand der Ausrichtungsmarkierungen (20), die an der Oberfläche (O.1) angeordnet sind, wobei ausgehend von der bereits strukturierten Strukturierung (S.11) der jeweils vorhergehenden (N-1) Teilstruktur (11) durch ortsaufgelöstes (X, Y, Z) Belichten entsprechend der in der Nten (N ≥ 2 bis n) virtuellen Photomaske (M.12, M.13, ) festgelegten individuellen Belichtungsdosis eine Strukturierung (S.12, S.13, ) der Nten (N ≥ 2 bis n) Teilstruktur (12, 13, ) in das jeweils vorhergehende (N-1) Zwischenprodukt (21) eines teilweise strukturierten Trägermaterials geschrieben wird, wobei die Strukturierung (S.12, S.13, ) der Nten (N ≥ 2 bis n) Teilstruktur (12, 13, ) innerhalb des Trägermaterials (1) jeweils tiefer liegt als die Strukturierung (S.11) der jeweils vorhergehenden (N-1) Teilstruktur (11);
- l- Nasschemisches Entwickeln des durch die Nte (N ≥ 2 bis n) virtuelle Photomaske (M.12, M.13) vorgegebenen belichteten Abschnitts des Trägermaterials (1), wobei die Oberflächen der Strukturierung (S.12, S.13, ) der Nten (N ≥ 2 bis n) Teilstruktur (12, 13, ) in Abhängigkeit von einer Entwicklungsrate des Trägermaterials (1) sowie von der berechneten Belichtungsdosis geglättet werden, bis die Oberflächen der Strukturierung (S.11) nach dem Belichten und Entwickeln (E) optisch glatt (G) sind;
- m- Erforderlichenfalls entsprechendes Wiederholen einer Abfolge der Schritte -j-(Positionieren jeweils einer weiteren virtuellen Photomaske), -k- (Weiteres Belichten) und -1- (Weiteres Entwickeln), bis schichtweise sämtliche N (N ≥ 2 bis n) virtuellen Photomasken (M.11, M.12, M.13, ) strukturiert wurden;
- n- Erhalten eines fertig strukturierten Trägermaterials (30), wobei das fertig strukturierte Trägermaterial (30) eine Strukturierung entsprechend dem gesamten Strukturmodell (S. 10) und seiner Gesamthöhe (H.10) enthält.

2. Verfahren nach Anspruch 1, **dadurch gekennzeichnet, dass** das photostrukturierbare Trägermaterial (1) ein positiv-arbeitender Photolack ist, bei dem belichtete Abschnitte beim nachfolgenden nasschemischen Entwickeln aus dem Trägermaterial (1) herausgelöst werden.

3. Verfahren nach Anspruch 1 oder 2, **dadurch gekennzeichnet, dass** das ausgerichtete Belichten des Trägermaterials (1) mittels maskenloser Laserlithographie, die auf Ein-Photonen- und/oder Zwei-Photonen-Absorption basiert, oder mittels optischer maskenloser Lithographie, wobei ein räumlicher Lichtmodulator und eine Abbildungsoptik verwendet werden, durchgeführt wird.

4. Verfahren nach einem der Ansprüche 1 bis 3, **dadurch gekennzeichnet, dass** zumindest eine virtuelle Photomaske (M.11, M.12, M.13) anhand von Ausrichtungsmarkierungen (20) auf der Oberfläche (O.1) eines unter einem Kippwinkel (α) gekippt angeordneten Trägermaterials (1) positioniert wird.

5. Verfahren nach Anspruch 4, **dadurch gekennzeichnet, dass** das ausgerichtete Belichten des Trägermaterials (1) sowie das nachfolgende nasschemische Entwickeln (E) des durch die zumindest eine virtuelle Photomaske (M.11, M.12, M.13) vorgegebenen belichteten Abschnitts des Trägermaterials (1) anhand von Ausrichtungsmarkierungen (20) auf der Oberfläche (O.1) eines unter einem Kippwinkel (α) gekippt angeordneten Trägermaterials (1) erfolgt.

6. Verfahren nach einem der Ansprüche 1 bis 5, **dadurch gekennzeichnet, dass** das photostrukturierbare Trägermaterial (1) eine Schichthöhe (H.1) größer als 100 µm, vorzugsweise größer als 200 µm, besonders bevorzugt größer als 500 µm, aufweist, wobei das Trägermaterial (1) vorzugsweise mehrlagig (1.1, 1.2, 1.3,1.4) auf dem Substratträger (2) aufgebracht wird.

7. Verfahren nach einem der Ansprüche 1 bis 6, **dadurch gekennzeichnet, dass** die Gesamthöhe (H.10) des Strukturmodells (10) größer als 100 µm ist.

8. Verfahren nach einem der Ansprüche 1 bis 7, **dadurch gekennzeichnet, dass** die Anzahl N (N ≥ 2 bis n) so ausgewählt wird, dass jede der N (N ≥ 2 bis n) Teilhöhen (H.11, H.12, H.13, ) der einzelnen Teilstrukturen (11, 12, 13, ) kleiner oder gleich einer maximalen Nenneindringtiefe ist, vorzugsweise kleiner ist als 30 µm, besonders bevorzugt kleiner ist als 20 µm.

9. Verfahren nach einem der Ansprüche 1 bis 8, **dadurch gekennzeichnet, dass** die Anzahl N (N ≥ 2 bis n) so ausgewählt wird, dass jede der N (N ≥ 2 bis n) Teilhöhen (H.11, H.12, H.13, ) der einzelnen Teilstrukturen (11, 12, 13, ) dieselbe Teilhöhe aufweist, welche Teilhöhe kleiner oder gleich einer maximalen Nenneindringtiefe ist, vorzugsweise kleiner ist als 30 µm, besonders bevorzugt kleiner ist als 20 µm.

10. Verfahren nach einem der Ansprüche 1 bis 9, **dadurch gekennzeichnet, dass** die optisch glatten Oberflächen (G) der Teilstrukturen (S.11, S.12, S.13) nach dem Belichten und Entwickeln (E) eine Rauheit mit einem Mittenrauwert von höchstens 50 nm, bevorzugt von höchstens 40 nm, besonders bevorzugt von höchstens 30 nm, aufweisen.

## Claims

1. Lithographic process for imprinting three-dimensional microstructures, which have oversized structure heights, in a photostructurable carrier material using an exposure device, wherein, in dependence on exposure parameters of the exposure device in connection with exposure properties of the photostructurable carrier material, a maximum nominal penetration depth of the exposure and thus a resulting photostructuring of the carrier material is accompanied and an oversized structure height has a height which exceeds the value of the maximum nominal penetration depth, the method comprising the following method steps:
- a- Depositing a photostructurable carrier material (1) over a surface on a substrate carrier (2), the deposited carrier material (1) having a layer height (H.1) and having a planar surface (O.1) on the upper side opposite the substrate carrier (2), and the properties of the carrier material (1) being changeable by exposure to electromagnetic radiation;
- b- taking information data as input, said information data including information on the maximum nominal penetration depth of the selected photostructurable substrate material (1) and on the geometric shape of a three-dimensional microstructure to be imprinted having an oversized structure height;
- c- computer-aided modeling of a virtual three-dimensional structure model (10) of the microstructure to be imprinted as a function of the information data according to step -b-, wherein the structure model (10) comprises topography data (T.10) of the microstructure to be imprinted and, on the basis of the topography data (T.10 ) is used to determine a total height (H.10) of the structure model (10) relative to the microstructure to be molded, which total height (H.10) is greater than the maximum nominal penetration depth of the electromagnetic radiation during exposure to the substrate material (1) and smaller than the applied layer height (H.1) of the substrate material (1);
- d- computer-assisted subdivision of the total height (H.10 ) of the three-dimensional structural model (10) into a number N (N ≥ 2 to n) of sequentially stacked height layers, wherein each of the N (N ≥ 2 to n) height layers corresponds to a single partial structure (11, 12, 13, ) of the structural model (10), and wherein each single one of the N (N ≥ 2 to n) partial structures (11, 12, 13, ) has a respective partial height ". 11, H.12, H.13, ), wherein the number N is an integer greater than or equal to the number 2, and wherein the number N (N ≥ 2 to n) is selected such that each of the N (N ≥ 2 to n) partial heights (H.11, H.12, H.13, ) is less than or equal to the possible nominal penetration depth of the electromagnetic radiation deliverable by the exposure device when exposed into the substrate (1), wherein the sum of the N (N ≥ 2 to n) partial heights (H.11, H.12, H.13, ) of the individual partial structures (11, 12, 13, ) corresponds to the total height (H.10) of the structure model (10);
- e- calculating a virtual photomask (M.11, M.12, M.13, ) for each one of the N (N ≥ 2 to n) substructures (11, 12, 13, ) of the structural model (10), wherein for each one of the N (N ≥ 2 to n) photomasks (M.11, M.12, M.13, ) the respective topography data (T.11, T.12, T.13, ) of each individual substructure (11, 12, 13, ) are converted into corresponding values of an individual exposure dose, wherein the exposure dose calculated for a specific location (X, Y, Z) of a substructure (11, 12, 13, ) correlates with the individual height position (Z) of the same location (X, Y, Z) within the corresponding substructure (11, 12, 13, );
- f- positioning a first virtual photomask (M.11) corresponding to the first substructure (11) in the lowest height layer of the structural model (10), and alignment marks (20) on the surface (O.1) of the substrate (1);
- g- aligned exposure of the carrier material (1) on the basis of the alignment markings (20) arranged on the surface (O.1), wherein, starting from the surface (O.1) of the carrier material (1), a structuring (S.11) of the first partial structure (11) is written into the carrier material (1) by spatially resolved (X, Y, Z) exposure in accordance with the individual exposure dose determined in the first virtual photomask (M.11);
- h- wet-chemical development (E) of the exposed section of the carrier material (1) predetermined by the first virtual photomask (M.11), the surfaces of the patterning (S.11) of the first partial structure (11) being smoothed as a function of a development rate of the carrier material (1) and of the calculated exposure dose until the surfaces of the patterning (S.11) are optically smooth (G) after the exposure and development (E);
- i- obtaining a first intermediate product (21) of a partially patterned support material, said first intermediate product (21) comprising a patterning (S.11) of said first partial structure (11);
- j- positioning a further Nth (N ≥ 2 to n) virtual photomask (M.12, M.13,), wherein the Nth (N ≥ 2 to n) virtual photomask (M.12, M.13, ) corresponds to the Nth (N ≥ 2 to n) substructure (12, 13, ) in the next-highest Nth (N ≥ 2 to n) height layer of the structure model (10) sequentially following the respective preceding (N-1) height layer, within the already structured structuring (S.11) of the respective preceding (N-1) substructure (11) of the respective preceding (N-1) intermediate (21);
- k- aligned further exposure of the respective preceding (N-1) intermediate product (21, 22, 23, ) on the basis of the alignment markings (20) arranged on the surface (O.1), wherein, starting from the already structured patterning (S.11) of the respective preceding (N-1) partial structure (11) by spatially resolved (X, Y, Z) exposure in accordance with the individual exposure dose determined in the Nth (N ≥ 2 to n) virtual photomask (M.12, M.13,), a patterning (S.12, S.13,) of the Nth (N ≥ 2 to n) partial structure (12, 13, ) is written into the respective preceding (N-1) intermediate product (21) of a partially patterned substrate material, wherein the patterning (S.12, S.13,) of the Nth (N ≥ 2 to n) partial structure (12, 13,) within the carrier material (1) in each case lies deeper than the structuring (S.11) of the respective preceding (N-1) partial structure (11);
- l- wet chemical development of the exposed section of the carrier material (1) predetermined by the Nths (N ≥ 2 to n) virtual photomask (M.12, M.13), wherein the surfaces of the structuring (S.12, S.13, ) of the Nth (N ≥ 2 to n) partial structure (12, 13, ) are smoothed as a function of a development rate of the carrier material (1) and of the calculated exposure dose until the surfaces of the structuring (S.11) are optically smooth (G) after exposure and development (E);
- m- if necessary, correspondingly repeating a sequence of steps -j- (positioning of one further virtual photomask each), -k- (further exposure) and -1- (further development) until all N (N ≥ 2 to n) virtual photomasks (M.11, M.12, M.13, ) have been patterned layer by layer;
- n- obtaining a final patterned substrate (30), wherein the final patterned substrate (30) contains a patterning corresponding to the total pattern (S. 10) and its total height (H.10).

2. Process according to claim 1, **characterized in that** the photostructurable support material (1) is a positive-working photoresist, in which exposed sections are dissolved out of the support material (1) during subsequent wet-chemical development.

3. Process according to claim 1 or 2, **characterized in that** the aligned exposure of the substrate (1) is performed by means of maskless laser lithography based on single-photon and/or two-photon absorption or by means of optical maskless lithography using a spatial light modulator and imaging optics.

4. Process according to any one of claims 1 to 3, **characterized in that** at least one virtual photomask (M.11, M.12, M.13) is positioned on the surface (O.1) of a substrate (1) tilted at a tilt angle (α) using alignment marks (20).

5. Process according to claim 4, **characterized in that** the aligned exposure of the carrier material (1) and the subsequent wet-chemical development (E) of the exposed section of the carrier material (1) predetermined by the at least one virtual photomask (M.11, M.12, M.13) is carried out on the basis of alignment marks (20) on the surface (O.1) of a carrier material (1) arranged tilted at a tilt angle (α).

6. Process according to one of claims 1 to 5, **characterized in that** the photostructurable carrier material (1) has a layer height (H.1) greater than 100 µm, preferably greater than 200 µm, particularly preferably greater than 500 µm, the carrier material (1) preferably being applied in multiple layers (1.1, 1.2, 1.3, 1.4) to the substrate carrier (2).

7. Process according to any one of claims 1 to 6, **characterized in that** the total height (H.10) of the structural model (10) is greater than 100 µm.

8. Process according to any one of claims 1 to 7, **characterized in that** the number N (N ≥ 2 to n) is selected such that each of the N (N ≥ 2 to n) partial heights (H.11, H.12, H.13,) of the individual partial structures (11, 12, 13, ) is less than or equal to a maximum nominal penetration depth, preferably less than 30 µm, more preferably less than 20 µm.

9. Process according to any one of claims 1 to 8, **characterized in that** the number N (N ≥ 2 to n) is selected such that each of the N (N ≥ 2 to n) partial heights (H.11, H.12, H.13,) of the individual partial structures (11, 12, 13, ) has the same partial height, which partial height is smaller than or equal to a maximum nominal penetration depth, preferably smaller than 30 µm, more preferably smaller than 20 µm.

10. Process according to one of claims 1 to 9, **characterized in that** the optically smooth surfaces (G) of the substructures (S.11, S.12, S.13) after exposure and development (E) have a roughness with a center-line roughness value of at most 50 nm, preferably at most 40 nm, particularly preferably at most 30 nm.

## Revendications

1. Procédé lithographique pour l'impression de microstructures tridimensionnelles, qui présentent des hauteurs de structure surdimensionnées, dans un matériau support photostructurable en utilisant un dispositif d'exposition, dans lequel, en fonction de paramètres d'exposition du dispositif d'exposition en relation avec des propriétés d'exposition du matériau de support photostructurable, une profondeur maximale de la bague nominale de l'exposition et donc une photostructuration résultante du matériau de support vont de pair et une hauteur de structure surdimensionnée présente une hauteur qui dépasse la valeur de la profondeur maximale de la bague nominale, le procédé comprenant les étapes de procédé suivantes :
- a- application en surface d'un matériau support (1) pouvant être photostructuré sur un support de substrat (2), le matériau support (1) appliqué présentant une hauteur de couche (H.1) ainsi qu'une surface plane (O.1) sur la face supérieure opposée au support de substrat (2), et les propriétés du matériau support (1) pouvant être modifiées par exposition à un rayonnement électromagnétique ;
- b- utilisation de données d'information comme grandeur d'entrée, ces données d'information contenant des indications sur la profondeur de pénétration nominale maximale du matériau support (1) photostructurable choisi ainsi que sur la forme géométrique d'une microstructure tridimensionnelle à imprimer présentant une hauteur de structure surdimensionnée ;
- c- modélisation assistée par ordinateur d'un modèle structurel tridimensionnel virtuel (10) de la microstructure à gaufrer en fonction des données d'information selon l'étape -b-, le modèle structurel (10) comprenant des données topographiques (T.10) de la microstructure à gaufrer et, à l'aide des données topographiques (T.10), on détermine la hauteur de la microstructure à gaufrer. ), on détermine une hauteur totale (H.10) du modèle structurel (10) par rapport à la microstructure à mouler, laquelle hauteur totale (H.10) est supérieure à la profondeur de pénétration nominale maximale du rayonnement électromagnétique lors de l'exposition dans le matériau de support (1) et inférieure à la hauteur de couche appliquée (H.1) du matériau de support (1) ;
- d- Subdivision assistée par ordinateur de la hauteur totale (H.10 ) du modèle structurel tridimensionnel (10) en un nombre N (N ≥ 2 à n) de couches de hauteur empilées séquentiellement les unes sur les autres, chacune des N (N ≥ 2 à n) couches de hauteur correspondant à une structure partielle individuelle (11, 12, 13,) du modèle structurel (10), et chacune des N (N ≥ 2 à n) structures partielles (11, 12, 13, ) ayant respectivement une hauteur partielle (H.11, H.12, H.13, ), le nombre N étant un nombre entier supérieur ou égal au nombre 2, et le nombre N (N ≥ 2 à n) étant choisi de telle sorte que chacune des N (N ≥ 2 à n) hauteurs partielles (H.11, H.12, H.13,) est inférieure ou égale à la profondeur d'anneau nominale possible du rayonnement électromagnétique pouvant être fourni par le dispositif d'exposition lors de l'exposition dans le matériau de support (1), la somme des N (N ≥ 2 à n) hauteurs partielles (H.11, H.12, H.13, ) des différentes structures partielles (11, 12, 13,) correspondant à la hauteur totale (H.10) du modèle de structure (10) ;
- e- calculer un photomasque virtuel (M.11, M.12, M.13,) pour chacune des N (N ≥ 2 à n) sous-structures (11, 12, 13, ) du modèle structurel (10), dans lequel, pour chacun des N (N ≥ 2 à n) photomasques (M.11, M.12, M.13, ), les données topographiques respectives (T.11, T.12, T.13, ) de chaque sous-structure individuelle (11, 12, 13, ) sont converties en valeurs correspondantes d'une dose d'exposition individuelle, la dose d'exposition calculée pour un lieu déterminé (X, Y, Z) d'une sous-structure (11, 12, 13, ) étant corrélée avec l'altitude individuelle (Z) du même lieu (X, Y, Z) à l'intérieur de la sous-structure correspondante (11, 12, 13, ) ;
- f- positionnement d'un premier photomasque virtuel (M.11) correspondant à la première structure partielle (11) dans la couche de hauteur la plus basse du modèle de structure (10), ainsi que de repères d'alignement (20) sur la surface (O.1) du matériau de support (1) ;
- g- exposition orientée du matériau de support (1) à l'aide des repères d'orientation (20) qui sont disposés sur la surface (O.1), une structuration (S.11) de la première structure partielle (11) étant inscrite dans le matériau de support (1) à partir de la surface (O.1) du matériau de support (1) par exposition résolue en fonction de l'endroit (X, Y, Z) en fonction de la dose d'exposition individuelle définie dans le premier photomasque virtuel (M.11) ;
- h- développement chimique par voie humide (E) de la section exposée du matériau support (1) prédéfinie par le premier photomasque virtuel (M.11), les surfaces de la structuration (S.11) de la première structure partielle (11) étant lissées en fonction d'un taux de développement du matériau support (1) ainsi que de la dose d'exposition calculée, jusqu'à ce que les surfaces de la structuration (S.11) soient optiquement lisses (G) après l'exposition et le développement (E) ;
- i- obtenir un premier produit intermédiaire (21) d'un matériau de support partiellement structuré, le premier produit intermédiaire (21) contenant une structuration (S.11) de la première structure partielle (11) ;
- j- positionner un autre Nte (N ≥ 2 à n) photomasque virtuel (M.12, M.13,), les Nte (N ≥ 2 à n) photomasques virtuels (M.12, M.13, ) de la Nte (N ≥ 2 à n) structure partielle (12, 13, ) dans la Nte (N ≥ 2 à n) couche de hauteur du modèle structurel (10) qui suit séquentiellement la (N-1) couche de hauteur respectivement précédente, correspond à l'intérieur de la structuration déjà structurée (S.11) de la (N-1) structure partielle (11) respectivement précédente du (N-1) produit intermédiaire (21) respectivement précédent ;
- k- poursuite de l'exposition orientée du (N-1) produit intermédiaire (21, 22, 23, ) respectivement précédent à l'aide des repères d'orientation (20) qui sont disposés sur la surface (O.1), dans lequel, à partir de la structuration (S.11) déjà structurée de la (N-1) structure partielle (11) respectivement précédente, par exposition résolue en fonction de la position (X, Y, Z), conformément à la valeur d'exposition définie dans le Nième (N ≥ 2 à n) photomasque virtuel (M.12, M.13, ), une structuration (S.12, S.13, ) de la Nten (N ≥ 2 à n) structure partielle (12, 13, ) est inscrite dans le (N-1) produit intermédiaire (21) respectivement précédent d'un matériau support partiellement structuré, la structuration (S.12, S.13, ) de la nième (N ≥ 2 à n) structure partielle (12, 13, ) à l'intérieur du matériau support (1) est respectivement plus profonde que la structuration (5.11) de la (N-1) structure partielle (11) respectivement précédente ;
- l- développement par voie chimique humide de la section exposée du matériau de support (1) prédéfinie par les Nte (N ≥ 2 à n) photomasques virtuels (M.12, M.13), les surfaces de la structuration (S.12, S.13, ) des N-ième (N ≥ 2 à n) sous-structures (12, 13, ) sont lissées en fonction d'un taux de développement du matériau support (1) ainsi que de la dose d'exposition calculée, jusqu'à ce que les surfaces de la structuration (5.11) soient optiquement lisses (G) après l'exposition et le développement (E) ;
- m- si nécessaire, répéter en conséquence une séquence des étapes -j- (positionnement d'un autre photomasque virtuel à la fois), -k- (exposition supplémentaire) et -1- (développement supplémentaire) jusqu'à ce que tous les N (N ≥ 2 à n) photomasques virtuels (M.11, M.12, M.13, ) aient été structurés couche par couche ;
- n- obtention d'un matériau support (30) structuré fini, le matériau support (30) structuré fini comprenant une structuration correspondant à l'ensemble du modèle de structure (S.10) et à sa hauteur totale (H.10).

2. Procédé selon la revendication 1, **caractérisé en ce que** le matériau support (1) pouvant être photostructuré est une laque photosensible travaillant en positif, dans laquelle des sections exposées sont détachées du matériau support (1) lors du développement chimique humide suivant.

3. Procédé selon la revendication 1 ou 2, **caractérisé en ce que** l'exposition alignée du matériau de support (1) est réalisée au moyen d'une lithographie laser sans masque, basée sur l'absorption d'un photon et/ou de deux photons, ou au moyen d'une lithographie optique sans masque, utilisant un modulateur spatial de lumière et une optique de formation d'image.

4. Procédé selon l'une des revendications 1 à 3, **caractérisé en ce qu'**au moins un photomasque virtuel (M.11, M.12, M.13) est positionné à l'aide de repères d'alignement (20) sur la surface (O.1) d'un matériau support (1) incliné selon un angle d'inclinaison (α).

5. Procédé selon la revendication 4, **caractérisé en ce que** l'exposition alignée du matériau de support (1) ainsi que le développement chimique humide (E) subséquent de la section exposée du matériau de support (1) prédéfinie par le au moins un photomasque virtuel (M.11, M.12, M.13) sont réalisés à l'aide de repères d'alignement (20) sur la surface (O.1) d'un matériau de support (1) disposé de manière inclinée sous un angle d'inclinaison (α).

6. Procédé selon l'une des revendications 1 à 5, **caractérisé en ce que** le matériau support (1) photostructurable présente une hauteur de couche (H.1) supérieure à 100 µm, de préférence supérieure à 200 µm, de manière particulièrement préférée supérieure à 500 µm, le matériau support (1) étant de préférence déposé en plusieurs couches (1.1, 1.2, 1.3, 1.4) sur le support substrat (2).

7. Procédé selon l'une des revendications 1 à 6, **caractérisé en ce que** la hauteur totale (H.10) du modèle structurel (10) est supérieure à 100 µm.

8. Procédé selon l'une des revendications 1 à 7, **caractérisé en ce que** le nombre N (N ≥ 2 à n) est choisi de manière à ce que chacune des N (N ≥ 2 à n) hauteurs partielles (H.11, H.12, H.13) des différentes sous-structures (11, 12, 13) soit inférieure ou égale à une profondeur maximale de la gorge nominale, de préférence inférieure à 30 µm, de manière particulièrement préférée inférieure à 20 µm.

9. Procédé selon l'une quelconque des revendications 1 à 8, **caractérisé en ce que** le nombre N (N ≥ 2 à n) est choisi de telle sorte que chacune des N (N ≥ 2 à n) hauteurs partielles (H.11, H.12, H.13) des différentes structures partielles (11, 12, 13) présente la même hauteur partielle, laquelle hauteur partielle est inférieure ou égale à une profondeur maximale de la gorge nominale, de préférence inférieure à 30 µm, de manière particulièrement préférée inférieure à 20 µm.

10. Procédé selon l'une des revendications 1 à 9, **caractérisé en ce que** les surfaces optiquement lisses (G) des structures partielles (S.11, S.12, S.13) présentent, après l'exposition et le développement (E), une rugosité ayant une valeur de rugosité moyenne d'au plus 50 nm, de préférence d'au plus 40 nm, de manière particulièrement préférée d'au plus 30 nm.
